# EUROPEAN PATENT APPLICATION

(11) **EP 4 632 808 A1**
(43) Date of publication of application: **15.10.2025**
(21) Application number: 24197858.4
(22) Date of filing: 02.09.2024
(51) Int. Cl.: H01L 23/473, H05K 5/06, H05K 7/20

(54) **SEMICONDUCTOR DEVICE HAVING LIQUID COOLING STRUCTURE**

(30) Priority: 12.04.2024 KR 20240049408
(71) Applicant: Samsung Electronics Co., Ltd, Suwon-si, Gyeonggi-do 16677 (KR)
(72) Inventor: KIM, Dongkyun, 16678 Suwon-si (KR); KANG, Sungchan, 16678 Suwon-si (KR); SON, Daehyuk, 16678 Suwon-si (KR); LEE, Hotaik, 16678 Suwon-si (KR); HONG, Seogwoo, 16678 Suwon-si (KR)
(74) Representative: Elkington and Fife LLP

(57) **Abstract**

A semiconductor device includes a semiconductor chip including a semiconductor integrated circuit; a cooling block including a first shower block and a second shower block stacked on the first shower block such that the first shower block and the second shower block define a cavity in which the at least one semiconductor chip is accommodated; and a printed circuit board, wherein the at least one cooling block is on the printed circuit board. The first shower block includes: first nozzles configured to spray a cooling liquid into the cavity toward a top surface of the semiconductor chip; and first outlets that receive the cooling liquid from the cavity, and the second shower block includes: second nozzles configured to spray the cooling liquid into the cavity toward a bottom surface of the semiconductor chip; and second outlets that receive the cooling liquid from the cavity.

## Description

### FIELD OF THE INVENTION

Embodiments of the present disclosure relate to a semiconductor device having a cooling structure.

### BACKGROUND OF THE INVENTION

To remove heat generated by electronic devices, air cooling devices have been mainly used. As the power density of electronic devices has gradually increased, the use of liquid cooling devices to cope with a large amount of heat has also increased. Moreover, to reduce the power consumption of data centers, there is gradually increasing interest in next-generation high-efficiency cooling devices such as liquid cooling devices. Liquid cooling devices may be classified, based on a temperature range of a heat-generating portion, into a single-phase liquid cooling method involving no phase change of a coolant and a two-phase liquid cooling method involving phase changes of a coolant. Two-phase liquid cooling methods are used to process heat in a wider range than single-phase liquid cooling methods.

### SUMMARY OF THE INVENTION

According to embodiments of the present disclosure, a semiconductor device having a liquid cooling structure is provided.

According to embodiments of the present disclosure, a semiconductor device capable of directly cooling a surface of an integrated circuit is provided.

Additional aspects will be set forth in part in the description which follows and, in part, will be apparent from the description, or may be learned by practice of the presented non-limiting example embodiments.

According to embodiments of the present disclosure, a semiconductor device may be provided and include: at least one semiconductor chip including a semiconductor integrated circuit; at least one cooling block including a first shower block and a second shower block stacked on the first shower block such that the first shower block and the second shower block define a cavity in which the at least one semiconductor chip is accommodated; and a printed circuit board, wherein the at least one cooling block is on the printed circuit board, wherein the first shower block includes: a plurality of first nozzles configured to spray a cooling liquid into the cavity toward a top surface of the at least one semiconductor chip; and a plurality of first outlets configured as a first discharge passage that receives the cooling liquid from the cavity, and wherein the second shower block includes: a plurality of second nozzles configured to spray the cooling liquid into the cavity toward a bottom surface of the at least one semiconductor chip; and a plurality of second outlets configured a second discharge passage that receives the cooling liquid from the cavity.

According to one or more embodiments of the present disclosure, the first shower block further includes: a plurality of first inlet channels that are configured to supply the cooling liquid to the plurality of first nozzles; and a plurality of first outlet channels connected to the plurality of first outlets, and the second shower block includes: a plurality of second inlet channels that are configured to supply the cooling liquid to the plurality of second nozzles; and a plurality of second outlet channels connected to the plurality of second outlets.

According to one or more embodiments of the present disclosure, the first shower block further includes a plurality of first block layers, and the plurality of first inlet channels and the plurality of first outlet channels are formed in different layers from among the plurality of first block layers, the second shower block further includes a plurality of second block layers, and the plurality of second inlet channels and the plurality of second outlet channels are formed in different layers from among the plurality of second block layers, and the plurality of first inlet channels and the plurality of first outlet channels are non-parallel to each other.

According to one or more embodiments of the present disclosure, the plurality of first inlet channels and the plurality of second inlet channels extend in a same direction as each other, and the plurality of first outlet channels and the plurality of second outlet channels extend in a same direction as each other.

According to one or more embodiments of the present disclosure, the semiconductor device further includes: an inlet manifold from which the plurality of first inlet channels and the plurality of second inlet channels branch, wherein the inlet manifold is in the at least one cooling block and communicates with an outside of the semiconductor device; and an outlet manifold to which the plurality of first outlet channels and the plurality of second outlet channels are joined, wherein the outlet manifold is in the at least one cooling block and communicates with the outside.

According to one or more embodiments of the present disclosure, the inlet manifold passes through the first shower block to communicate with the outside.

According to one or more embodiments of the present disclosure, the outlet manifold passes through the first shower block to communicate with the outside.

According to one or more embodiments of the present disclosure, the outlet manifold passes through the second shower block to communicate with the outside.

According to one or more embodiments of the present disclosure, the semiconductor device further includes: a plurality of first nozzle groups each including a subset of the plurality of first nozzles arranged from each other in a second direction, the plurality of first nozzle groups arranged from each other in a first direction, perpendicular to the second direction; and a plurality of first outlet groups each including a subset of the plurality of first outlets arranged in the second direction from each other, the plurality of first outlet groups arranged in the first direction from each other, wherein the plurality of first outlet groups are between the plurality of first nozzle groups.

According to one or more embodiments of the present disclosure, the first shower block further includes: a plurality of first inlet channels that are configured to supply the cooling liquid to the plurality of first nozzles; and a plurality of first outlet channels connected to the plurality of first outlets, wherein the plurality of first inlet channels extend in the first direction and are arranged in the second direction from each other, and wherein the plurality of first outlet channels extend in the second direction and are arranged in the first direction from each other.

According to one or more embodiments of the present disclosure, the second shower block is on the printed circuit board, and wherein the semiconductor device further includes a plurality of through-layer vias in the second shower block and electrically connecting the at least one semiconductor chip and the printed circuit board to each other.

According to one or more embodiments of the present disclosure, the semiconductor device further includes a plurality of nozzle-via groups each including a subset of the plurality of second nozzles arranged from each other in a second direction and the plurality of through-layer vias between the plurality of second nozzles, the plurality of nozzle-via groups arranged from each other in a first direction perpendicular to the second direction; and a plurality of second outlet groups each including a subset of the plurality of second outlets arranged in the first direction, the plurality of second outlet groups arranged from each other in the second direction such as to between the plurality of nozzle-via groups.

According to one or more embodiments of the present disclosure, the second shower block includes: a plurality of second inlet channels configured to supply the cooling liquid to the plurality of second nozzles; and a plurality of second outlet channels connected to the plurality of second outlets, wherein the plurality of second inlet channels extend in the first direction and are arranged from each other in the second direction, and wherein the plurality of second outlet channels extend in the second direction and are arranged from each other in the first direction.

According to one or more embodiments of the present disclosure, the cavity includes an upper cavity defined by the first shower block and a lower cavity defined by the second shower block, and wherein the upper cavity and the lower cavity are not connected to each other.

According to one or more embodiments of the present disclosure, the cavity includes an upper cavity defined by the first shower block and a lower cavity defined by the second shower block, and wherein the upper cavity and the lower cavity are in communication with each other.

According to one or more embodiments of the present disclosure, the at least one semiconductor chip is a plurality of semiconductor chips stacked on each other.

According to one or more embodiments of the present disclosure, the at least one cooling block is a first cooling block and a second cooling block on the first cooling block, wherein the at least one semiconductor chip includes at least one first semiconductor chip within the first cooling block and at least one second semiconductor chip within the second cooling block.

According to one or more embodiments of the present disclosure, the first shower block further includes: a plurality of first inlet channels configured to supply the cooling liquid to the plurality of first nozzles; and a plurality of first outlet channels connected to the plurality of first outlets, and the second shower block further includes: a plurality of second inlet channels configured to supply the cooling liquid to the plurality of second nozzles; and a plurality of second outlet channels connected to the plurality of second outlets, wherein the first cooling block includes: a first inlet manifold to which the plurality of first inlet channels and the plurality of second inlet channels are joined; and a first outlet manifold to which the plurality of first outlet channels and the plurality of second outlet channels are joined, wherein the second cooling block includes: a second inlet manifold to which the plurality of first inlet channels and the plurality of second inlet channels are joined; and a second outlet manifold to which the plurality of first outlet channels and the plurality of second outlet channels are joined, wherein the first inlet manifold and the second inlet manifold are connected to each other and communicate with an outside of the semiconductor device, and wherein the first outlet manifold and the second outlet manifold are connected to each other and communicate with the outside.

According to one or more embodiments of the present disclosure, at least of the plurality of first inlet channels of the first cooling block is connected to the plurality of second nozzles of the second cooling block such as to function as at least one of the plurality of second inlet channels of the second cooling block.

According to one or more embodiments of the present disclosure, the semiconductor device further includes a plurality of through-layer vias that electrically connect the at least one first semiconductor chip and the at least one second semiconductor chip to the printed circuit board.

### BRIEF DESCRIPTION OF DRAWINGS

The above and other aspects, features, and advantages of certain embodiments will be more apparent from the following description taken in conjunction with the accompanying drawings, in which:
FIG. 1 is a schematic cross-sectional view illustrating a semiconductor device, according to an embodiment;
FIG. 2 is a detailed view illustrating a portion D1 of FIG. 1;
FIG. 3 is a cross-sectional view taken along a line A1-A1' of FIG. 1, illustrating an example of an arrangement type of a plurality of first nozzles, a plurality of first outlets, a plurality of first inlet channels, and a plurality of first outlet channels;
FIGS. 4A to 4C are views illustrating the number of first nozzles according to various arrangement types of a plurality of first nozzle groups and a plurality of first outlet groups, in a structure in which a plurality of first inlet channels and a plurality of first outlet channels are perpendicular to each other;
FIGS. 5A to 5C are views illustrating the number of first nozzles according to various arrangement types of a plurality of first nozzle groups and a plurality of first outlet groups, in a structure according to a comparative example in which a plurality of first inlet channels and a plurality of first outlet channels are parallel to each other;
FIG. 6 is a cross-sectional view taken along a line A2-A2' of FIG. 1, illustrating an example of an arrangement type of a plurality of second nozzles, a plurality of second outlets, a plurality of second inlet channels, a plurality of second outlet channels, and a plurality of through-layer vias (TLVs);
FIG. 7 is a cross-sectional view taken along a line B2-B2' of FIG. 6;
FIG. 8 is a schematic cross-sectional view illustrating a semiconductor device, according to an embodiment;
FIG. 9 is a schematic cross-sectional view illustrating a semiconductor device, according to an embodiment;
FIG. 10 is a schematic cross-sectional view illustrating a semiconductor device, according to an embodiment;
FIGS. 11 and 12 are schematic cross-sectional views illustrating a semiconductor device, according to an embodiment; and
FIGS. 13 and 14 are schematic cross-sectional views illustrating a semiconductor device, according to an embodiment.

### DETAILED DESCRIPTION

Reference will now be made in detail to non-limiting example embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

In the drawings, sizes of elements may be exaggerated for clarity and convenience of explanation. When a first element is "on" or "over" a second element, it may include a case where the first element directly contacts the second element and is directly located on the top, bottom, left, or right of the second element, and a case where the first element does not directly contact the second element and is located on the top, bottom, left, or right of the second element with a third element therebetween. The singular forms "a," "an," and "the" are intended to include the plural forms as well, unless the context clearly indicates otherwise. When a part "includes" an element, another element may be further included, rather than excluding the existence of the other element, unless otherwise described. The use of the terms "a" and "an," and "the" and similar referents in the context of describing the present disclosure is to be construed to cover both the singular and the plural. The steps of all methods described herein may be performed in any suitable order unless otherwise indicated herein or otherwise clearly contradicted by context, and are not limited to the described order. Also, in the specification, the term "unit" or "module" indicates a unit for processing at least one function or operation, and may be implemented by hardware, software, or a combination of hardware and software. Also, lines or members connecting elements illustrated in the drawings are merely illustrative of functional connections and/or physical or circuit connections. In an actual device, the connections between elements may be represented by various functional connections, physical connections, or circuit connections that are replaceable or added. The use of any and all examples and example language provided herein is intended merely to better describe the present disclosure and does not pose a limitation on the scope of the present disclosure unless otherwise stated.

Efficient cooling systems are required to solve cooling problems acting as factors limiting the performance of electronic devices including semiconductor chips. In the fields of high-performance computing (HPC) and semiconductor devices including stacked three-dimensional (3D) semiconductor chips, liquid cooling systems are required to handle an increase in power density and an increase in the amount of heat generated by highly integrated circuits. To this end, embodiments of the present disclosure provide a semiconductor device having a multiple side shower cooling structure for cooling a semiconductor chip by supplying a cooling liquid onto two or more surfaces of the semiconductor chip. The multiple side shower cooling structure of embodiments of the present disclosure may be referred to as a multiple side jet impingement cooling structure. A semiconductor device may be referred to as a semiconductor chip package. In the following description, a first direction X refers to one of directions parallel to a top surface of a semiconductor chip. A second direction Y refers to a direction perpendicular to the first direction X from among the directions parallel to the top surface of the semiconductor chip. A third direction Z refers to a thickness direction of the semiconductor chip.

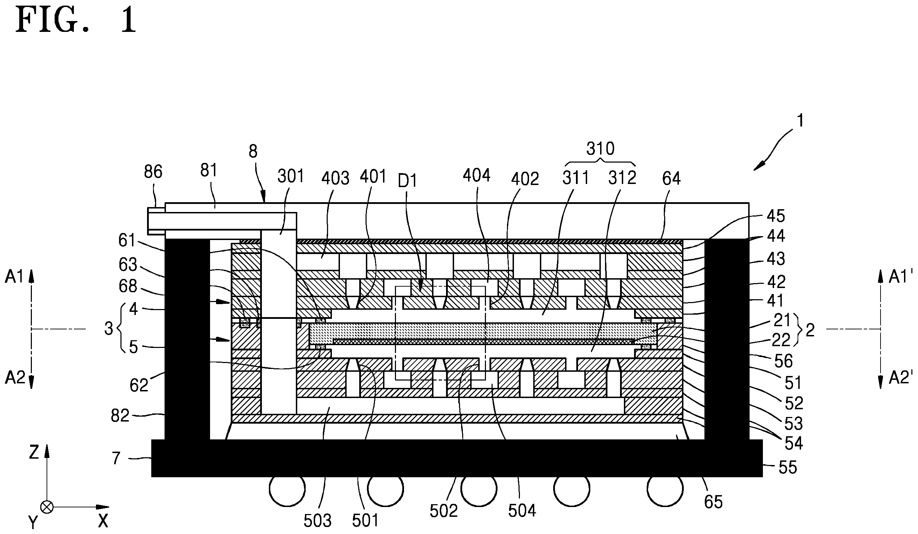

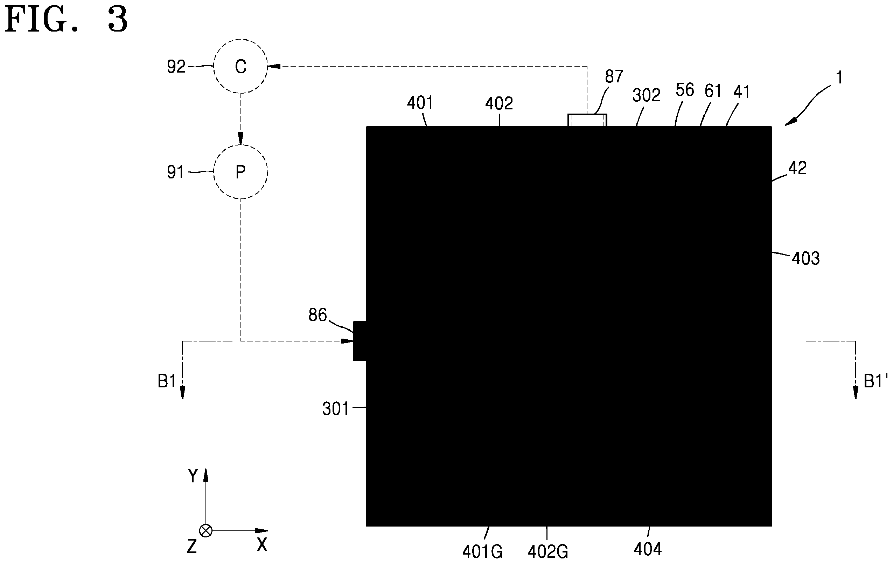

FIG. 1 is a schematic cross-sectional view illustrating a semiconductor device 1, according to an embodiment. FIG. 1 is a cross-sectional view taken along a line B1-B1' of FIG. 3 described below. Referring to FIG. 1, an embodiment of the semiconductor device 1 may include a semiconductor chip 2 and a cooling block 3. The embodiment of the semiconductor device 1 may further include a printed circuit board 7 electrically connected to the semiconductor chip 2, and a housing 8 covering the cooling block 3.

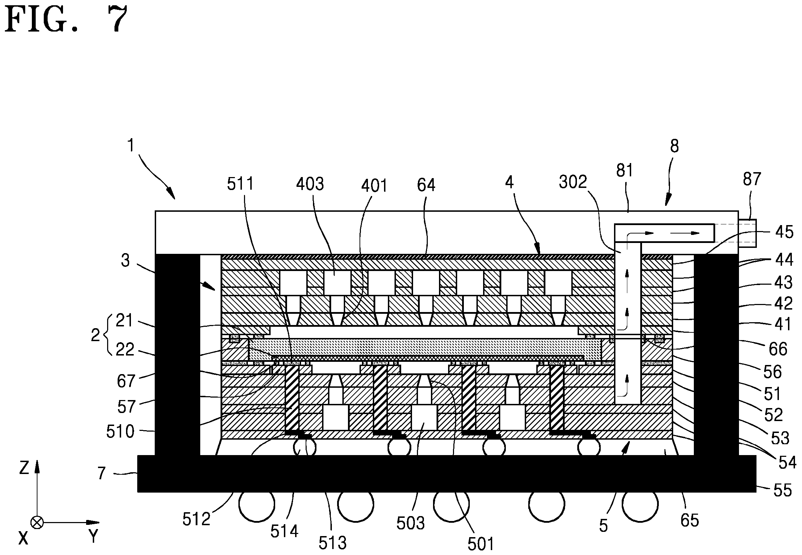

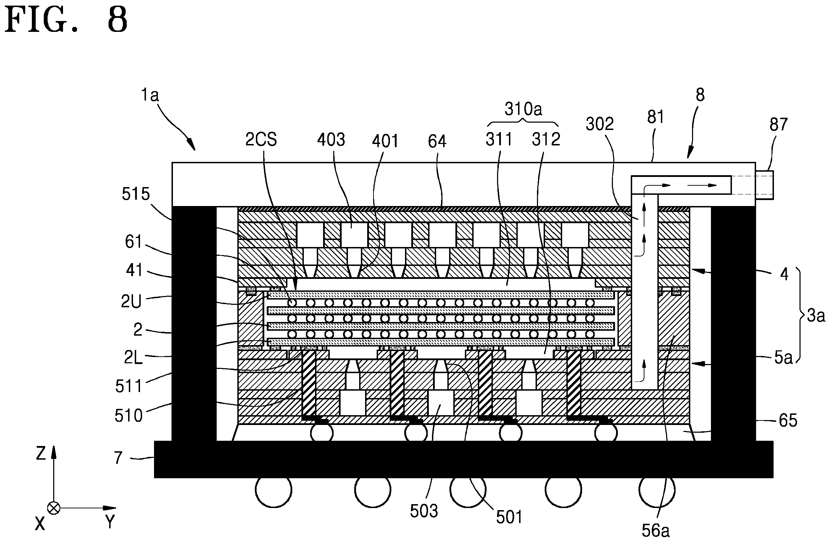

The semiconductor chip 2 may include a substrate 21 and a semiconductor integrated circuit 22 formed on at least one surface of the substrate 21. The semiconductor chip 2 may be any of various semiconductor integrated circuit chips. For example, the semiconductor chip 2 may be a memory chip including a memory integrated circuit, a logic chip including a logic integrated circuit, a central processing unit (CPU) chip, a graphics processing unit (GPU) chip, or an application-specific integrated circuit (ASIC) chip. To implement the semiconductor device 1 having a small form factor, the semiconductor chip 2 may be a wafer-level semiconductor integrated circuit chip. The substrate 21 may be a wafer. Electrical wiring elements for electrical connection between the semiconductor integrated circuit 22 and the printed circuit board 7 may be provided on at least one surface (e.g., a bottom surface) of the semiconductor chip 2. The electrical wiring elements are electrically passivated with respect to the outside. The semiconductor chip 2 may be electrically connected to the printed circuit board 7 through an electrical connection structure that at least partially passes through the cooling block 3, for example, a plurality of through-layer vias (TLVs) 510 (see FIG. 7) described below. The semiconductor chip 2 may be referred to as an integrated circuit die, and the semiconductor device 1 including the integrated circuit die may be referred to as an integrated circuit device. Although one semiconductor chip 2 is shown in FIG. 1, two or more semiconductor chips 2 may be arranged in a horizontal direction (e.g., the first direction X and/or the second direction Y). For example, the semiconductor chip 2 may be a hybrid semiconductor chip in which a plurality of semiconductor chip dies are arranged on one common die. As described below, a plurality of semiconductor chips 2 may be stacked to be electrically connected to each other to form a semiconductor chip stack 2CS (see FIG. 8) described below.

The cooling block 3 includes a cavity 310 in which the semiconductor chip 2 is accommodated. The cavity 310 may be referred to as a cooling chamber where cooling of the semiconductor chip 2 is performed. In an embodiment, the cooling block 3 may include a first shower block 4 and a second shower block 5. The first shower block 4 and the second shower block 5 are stacked on each other to form the cavity 310. The cavity 310 may include an upper cavity 311 that is between the first shower block 4 and the semiconductor chip 2, and a lower cavity 312 that is between the second shower block 5 and the semiconductor chip 2. For example, the upper cavity 311 may be defined by the first shower block 4 and the lower cavity 312 may be defined by the second shower block 5. In the present embodiment, the upper cavity 311 and the lower cavity 312 are not connected to each other. In other words, the cavity 310 is divided by the semiconductor chip 2 into the upper cavity 311 and the lower cavity 312, and a cooling liquid does not move from the upper cavity 311 to the lower cavity 312 or vice versa.

The cooling block 3 is supported on the printed circuit board 7. In an embodiment, the second shower block 5 of the cooling block 3 may be attached to the printed circuit board 7 by an adhesive layer 65. The cooling block 3 may have a structure capable of providing an impingement jet of a cooling liquid onto at least two surfaces (e.g., a top surface and a bottom surface) of the semiconductor chip 2.

The housing 8 covers the cooling block 3. The housing 8 may include an upper wall 81, and a side wall 82 extending from the upper wall 81 and supported on the printed circuit board 7. A top surface of the cooling block 3 (e.g., a first cover layer 45 described below) may be attached to the upper wall 81 of the housing 8 with a thermal interface material 64. The thermal interface material 64 may include at least one from among, for example, thermal grease, thermal adhesive, thermal gap filler, liquid metal, and solder. Because the thermal interface material 64 has high thermal conductivity, heat may be effectively transferred from the cooling block 3 to the housing 8, thereby contributing to improvement in the cooling efficiency of the semiconductor chip 2.

The first shower block 4 has a structure capable of supplying a cooling liquid into the cavity 310 toward the top surface of the semiconductor chip 2 and discharging the cooling liquid from the cavity 310. For example, the first shower block 4 may include a plurality of first nozzles 401 from which a cooling liquid is sprayed into the cavity 310 toward the top surface of the semiconductor chip 2, and a plurality of first outlets 402 arranged to form a discharge passage for the cooling liquid from the cavity 310. In other words, the plurality of first nozzles 401 and the plurality of first outlets 402 are open toward the upper cavity 311. The second shower block 5 has a structure capable of supplying a cooling liquid into the cavity 310 toward the bottom surface of the semiconductor chip 2 and discharging the cooling liquid from the cavity 310. The second shower block 5 may include a plurality of second nozzles 501 from which a cooling liquid is sprayed into the cavity 310 toward the bottom surface of the semiconductor chip 2, and a plurality of second outlets 502 arranged to form a discharge passage for the cooling liquid from the cavity 310. In other words, the plurality of second nozzles 501 and the plurality of second outlets 502 are open toward the lower cavity 312.

While the semiconductor chip 2 operates, heat is generated in the semiconductor integrated circuit 22. The heat is transferred from the semiconductor integrated circuit 22 to the substrate 21. The semiconductor chip 2 is cooled by cooling liquids supplied by the plurality of first nozzles 401 and the plurality of second nozzles 501. The plurality of first nozzles 401 and the plurality of second nozzles 501 provide an impingement jet (jet impingement) of a cooling liquid to the top surface and the bottom surface of the semiconductor chip 2. A cooling liquid in the cavity 310, where heat exchange with the semiconductor chip 2 has been completed, or cooling gas formed by vaporizing the cooling liquid is discharged from the cavity 310 through the plurality of first outlets 402 and the plurality of second outlets 502. In detail, a cooling liquid supplied to the upper cavity 311 by the plurality of first nozzles 401 is discharged from the upper cavity 311 through the plurality of first outlets 402 after heat exchange with the semiconductor chip 2. A cooling liquid supplied to the lower cavity 312 by the plurality of second nozzles 501 is discharged from the lower cavity 312 through the plurality of second outlets 502 after heat exchange with the semiconductor chip 2.

As such, according to the semiconductor device 1 according to an embodiment, the semiconductor chip 2 is cooled by an impingement jet (jet impingement) of a cooling liquid directly supplied to the top surface and the bottom surface of the semiconductor chip 2. That is, the cooling block 3 according to an embodiment has a multiple side cooling structure capable of providing an impingement jet of a cooling liquid to the top surface and the bottom surface of the semiconductor chip 2. Accordingly, the semiconductor device 1 according to an embodiment may have higher cooling efficiency than a structure for supplying a cooling liquid only to one surface of the semiconductor chip 2, and the semiconductor chip 2 may be cooled within a stable temperature range. Also, the semiconductor device 1 according to an embodiment may be applied to an electronic device having high power density and high heat generation.

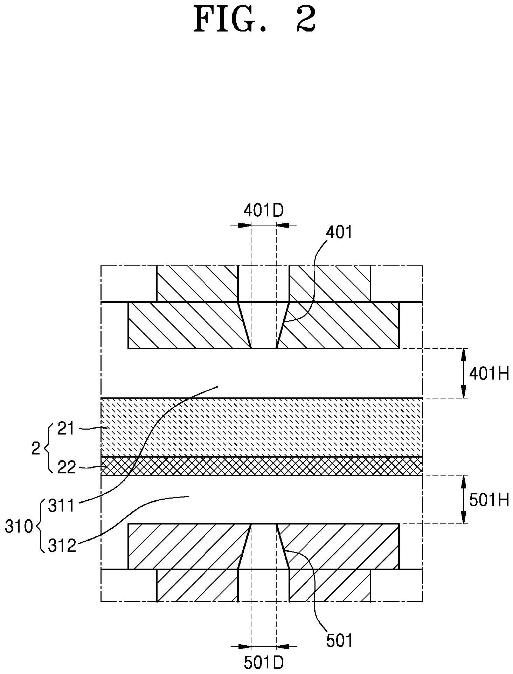

A ratio of a diameter of an outlet of a nozzle to a distance between the nozzle and a heat exchange surface may affect heat transfer efficiency. FIG. 2 is a detailed view illustrating a portion D1 of FIG. 1. Referring to FIG. 2, the first nozzle 401 is spaced apart from a top surface of the semiconductor chip 2, which is a heat exchange surface. A diameter 401D of an outlet of the first nozzle 401 and an interval 401H between the outlet of the first nozzle 401 and the top surface of the semiconductor chip 2 affect the strength of a cooing solution jet hitting the top surface of the semiconductor chip 2. The strength of the cooling liquid jet may be determined by considering heat transfer characteristics between the cooling liquid and the semiconductor chip 2. For a given speed of the cooling liquid jet, a ratio of the interval 401H between the outlet of the first nozzle 401 and the top surface of the semiconductor chip 2 to the diameter 401D of the outlet of the first nozzle 401, that is, a value of 401H/401D, may range from 3 to 4. In this range, high heat transfer efficiency is ensured between the cooling liquid and the semiconductor chip 2. The speed of the cooling liquid jet may vary according to the interval 401H between the outlet of the first nozzle 401 and the top surface of the semiconductor chip 2, and the speed of the cooling liquid jet may be determined to obtain optimal heat transfer efficiency by considering the interval 401H between the outlet of the first nozzle 401 and the top surface of the semiconductor chip 2.

The range of the ratio of the distance between the nozzle and the heat exchange surface to the diameter of the outlet of the nozzle may also apply to a bottom surface of the semiconductor chip 2 and the second nozzle 501. Accordingly, a ratio of an interval 501H between an outlet of the second nozzle 501 and a bottom surface of the semiconductor chip 2 to a diameter 501D of the outlet of the second nozzle 501, that is, a value of 501H/501D, may range from 3 to 4.

Referring back to FIG. 1, the first shower block 4 may include a plurality of first inlet channels 403 through which a cooling liquid is supplied to a plurality of first nozzles 401, and a plurality of first outlet channels 404 connected to a plurality of first outlets 402. The plurality of first inlet channels 403 and the plurality of first outlet channels 404 are located at different heights from each other in the first shower block 4. For example, the first shower block 4 may include a plurality of first block layers stacked on each other, and the plurality of first inlet channels 403 and the plurality of first outlet channels 404 may be formed in different first block layers from among the plurality of first block layers. In other words, the plurality of first inlet channels 403 may be formed in one of the plurality of first block layers, and the plurality of first outlet channels 404 may be formed in a first block layer different from the first block layer in which the plurality of first inlet channels 403 are formed from among the plurality of first block layers. Accordingly, the plurality of first inlet channels 403 and the plurality of first outlet channels 404 may not interfere with each other or may not be connected to each other.

In an embodiment, referring to FIG. 1, the plurality of first block layers of the first shower block 4 may include a first gap layer 41, a first nozzle layer 42, a first outlet channel layer 43, a first inlet channel layer 44, and the first cover layer 45 sequentially stacked from a side close to the semiconductor chip 2. The plurality of first nozzles 401 and the plurality of first outlets 402 are provided in the first nozzle layer 42. The first gap layer 41 is located between the first nozzle layer 42 and the semiconductor chip 2 to separate the first nozzle layer 42 from the semiconductor chip 2. Accordingly, the upper cavity 311 is formed between the semiconductor chip 2 and the first shower block 4. The first outlet channel layer 43 is located on the first nozzle layer 42. The plurality of first outlet channels 404 are provided in the first outlet channel layer 43. The plurality of first outlets 402 communicate with the plurality of first outlet channels 404. The first inlet channel layer 44 is located on the first outlet channel layer 43. The plurality of first inlet channels 403 are provided in the first inlet channel layer 44. The plurality of first nozzles 401 pass through the first outlet channel layer 43 without overlapping with the plurality of first inlet channels 403 to communicate with the plurality of first inlet channels 403. The first cover layer 45 is located on the first inlet channel layer 44 to cover the plurality of first inlet channels 403. Accordingly, a structure in which the plurality of first inlet channels 403 and the plurality of first outlet channels 404 are located at different heights in the first shower block 4 may be implemented.

The first shower block 4 is adhered to the top surface of the semiconductor chip 2 by a first inner sealing adhesive member 61. The first inner sealing adhesive member 61 is located between the first gap layer 41 and the top surface of the semiconductor chip 2. The first inner sealing adhesive member 61 may have a closed band shape located near an outside edge of the semiconductor chip 2, as shown in FIG. 3 described below. The first inner sealing adhesive member 61 prevents a cooling liquid from leaking out of the cavity 310, for example, the upper cavity 311. The interval 401H (see FIG. 2) between the outlet of the first nozzle 401 and the top surface of the semiconductor chip 2 may be determined by a thickness of the first gap layer 41 and a thickness of the first inner sealing adhesive member 61.

The plurality of first block layers of the first shower block 4 may be formed of, for example, silicon.

In an embodiment, the plurality of first inlet channels 403 are non-parallel to the plurality of first outlet channels 404. For example, the plurality of first inlet channels 403 may be perpendicular to the plurality of first outlet channels 404. FIG. 3 is a cross-sectional view taken along line A1-A1' of FIG. 1, illustrating an example of an arrangement type of the plurality of first nozzles 401, the plurality of first outlets 402, the plurality of first inlet channels 403, and the plurality of first outlet channels 404. In FIG. 3, the semiconductor chip 2 is not shown. Referring to FIG. 3, for example, the plurality of first nozzles 401 may be two-dimensionally arranged on a horizontal plane of the first nozzle layer 42. The plurality of first outlets 402 may be two-dimensionally arranged on the horizontal plane of the first nozzle layer 42 such as not to overlap with the plurality of first nozzles 401.

In an embodiment, the plurality of first nozzles 401 may be divided into a plurality of first nozzle groups 401G. Each first nozzle group 401G includes a plurality of first nozzles 401 arranged in the second direction Y. The plurality of first nozzle groups 401G are arranged from each other in the first direction X perpendicular to the second direction Y. The plurality of first outlets 402 may be divided into a plurality of first outlet groups 402G. Each first outlet group 402G includes a plurality of first outlets 402 arranged in the second direction Y. The plurality of first outlet groups 402G are arranged from each other in the first direction X. The plurality of first outlet groups 402G are located between the plurality of first nozzle groups 401G. That is, the first nozzle group 401G and the first outlet group 402G are alternately arranged in the first direction X. When "the first nozzle group 401G and the first outlet group 402G are alternately arranged in the first direction X", it does not mean only a case where one first nozzle group 401G and one first outlet group 402G are alternately arranged in the first direction X as shown in FIG. 3 but also includes a case where, for example, two or more first nozzle groups 401G and one or more first outlet groups 402G are alternately arranged in the first direction X.

For example, the plurality of first inlet channels 403 may extend in the first direction X. The plurality of first inlet channels 403 may be arranged from each other in the second direction Y. Each first inlet channel 403 is connected to the first nozzles 401 of the plurality of first nozzle groups 401G aligned in the first direction X (e.g., a corresponding one of the plurality of first nozzle groups 401G). The plurality of first outlet channels 404 may extend in a direction non-parallel to the plurality of first inlet channels 403, for example, in the second direction Y. The plurality of first outlet channels 404 may be arranged from each other in the first direction X. Each first outlet channel 404 is connected to the first outlets 402 of the plurality of first outlet groups 402G aligned in the second direction Y (e.g., a corresponding one of the plurality of first outlet groups 402G). Because the plurality of first inlet channels 403 and the plurality of first outlet channels 404 are located at different heights from each other, the plurality of first inlet channels 403 and the plurality of first outlet channels 404 may be arranged non-parallel to each other (e.g., may be arranged perpendicular to each other).

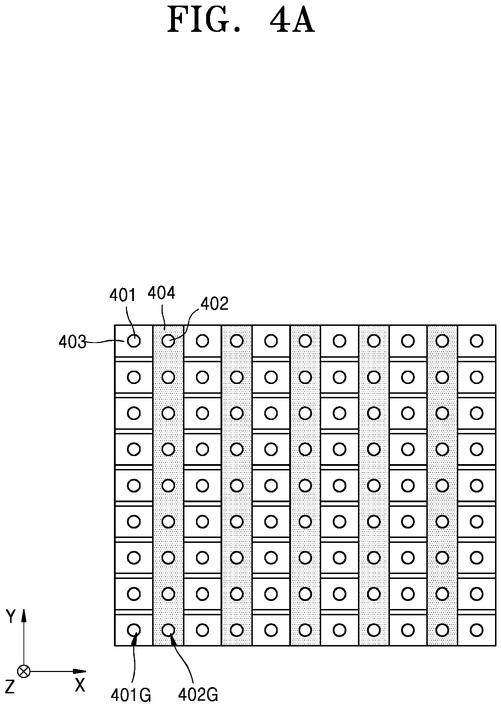

Such an arrangement type in which "the plurality of first inlet channels 403 and the plurality of first outlet channels 404 are arranged non-parallel to each other" allows as many first nozzles 401 as possible to face a heat exchange surface. Accordingly, the semiconductor chip 2 may be effectively cooled. FIGS. 4A to 4C are views illustrating the number of first nozzles 401 according to various arrangement types of the plurality of first nozzle groups 401G and the plurality of first outlet groups 402G, in a structure in which the plurality of first inlet channels 403 and the plurality of first outlet channels 404 are perpendicular to each other. In FIGS. 4A to 4C, widths of the first inlet channel 403 and the first outlet channel 404 are 0.5, and an interval of the first inlet channels 403 adjacent to each other in the second direction Y is 0.2. An interval between the first nozzles 401 adjacent each other in the first direction X is 0.5. An interval between the first nozzle 401 and the first outlet 402 in the first direction X is 0.5. Lengths of an entire arrangement area in the first direction X and the second direction Y are respectively 6 and 6.1.

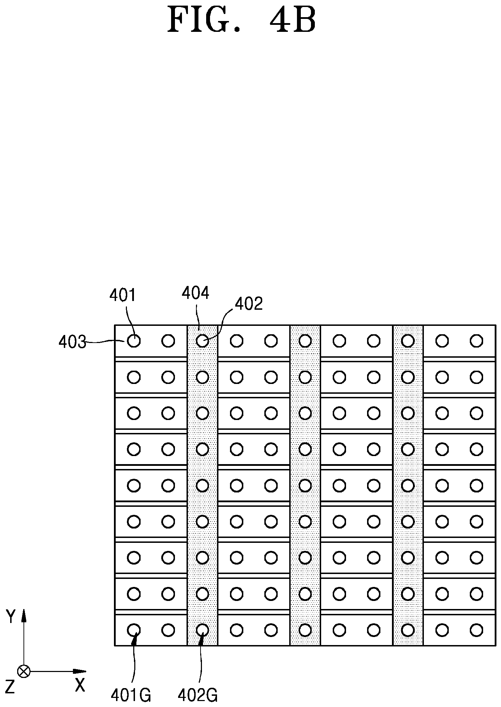

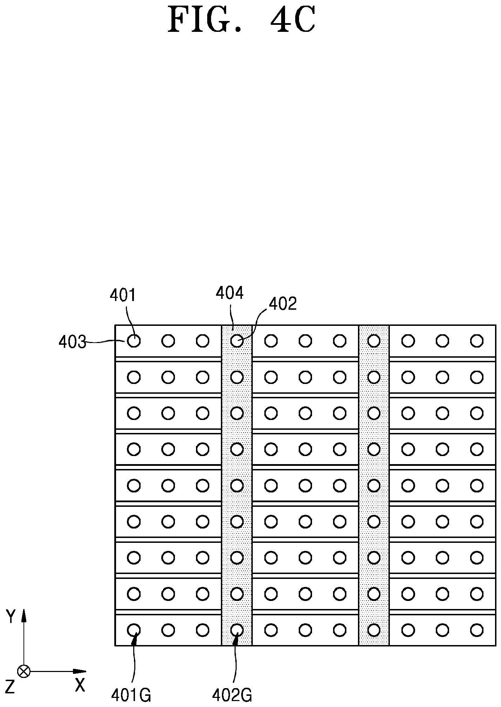

Referring to FIG. 4A, one first nozzle group 401G and one first outlet group 402G are alternately arranged in the first direction X. Six first nozzle groups 401G are arranged from each other in the first direction X. Each first nozzle group 401G includes nine first nozzles 401. Nine first inlet channels 403 extending in the first direction X are arranged from each other in the second direction Y. Five first outlet channels 404 extending in the second direction Y are arranged from each other in the first direction X. In FIG. 4A, the number of first nozzles 401 is 9×6 = 54. Referring to FIG. 4B, two first nozzle groups 401G and one first outlet group 402G are alternately arranged in the first direction X. The number of first nozzle groups 401G is 8. Accordingly, in FIG. 4B, the number of first nozzles 401 is 9×8 = 72. Referring to FIG. 4C, three first nozzle groups 401G and one first outlet group 402G are alternately arranged in the first direction X. The number of first nozzle groups 401G is 9. Accordingly, in FIG. 4C, the number of first nozzles 401 is 9×9 = 81.

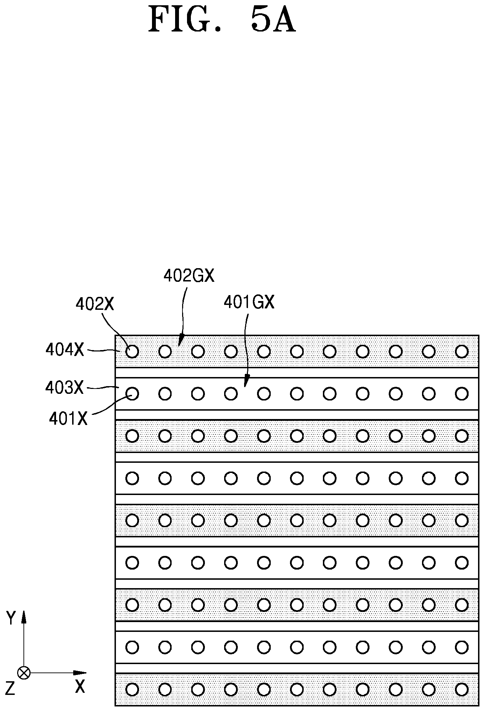

FIGS. 5A to 5C are views illustrating the number of first nozzles 401X according to various arrangement types of a plurality of first nozzle groups 401GX and a plurality of first outlet groups 402GX, in a structure according to a comparative example in which a plurality of first inlet channels 403X and a plurality of first outlet channels 404X are parallel to each other. In FIGS. 5A to 5C, widths of the first inlet channel 403X and the first outlet channel 404X is 0.5, and an interval of two adjacent ones of the first inlet channels 403X in the second direction Y and an interval between the first inlet channel 403X and the first outlet channel 404X in the second direction Y are 0.2. An interval between the first nozzles 401X in the first direction X is 0.5. An interval of the first outlets 402X in the first direction X is 0.5. Lengths of an entire arrangement area in the first direction X and the second direction Y are respectively 6 and 6.1.

In FIGS. 5A to 5C, the plurality of first nozzle groups 401GX extend in the first direction X and are arranged from each other in the second direction Y. The plurality of first outlet groups 402GX extend in the first direction X and are arranged in the second direction Y. The plurality of first inlet channels 403X extend in the first direction X to respectively correspond to the plurality of first nozzle groups 401GX and are arranged from each other in the second direction Y. The plurality of first outlet channels 404X extend in the first direction X to respectively correspond to the first outlet groups 402GX and are arranged in the second direction Y.

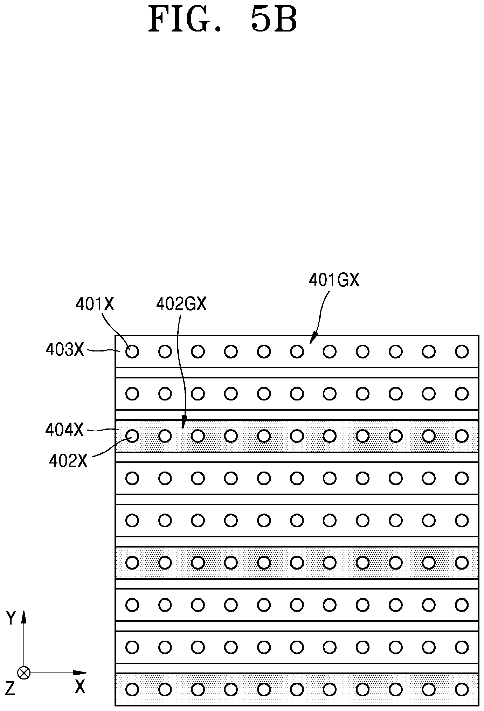

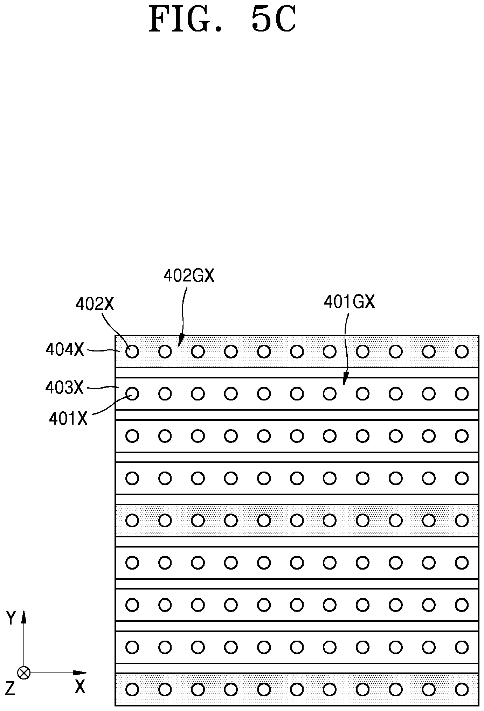

Referring to FIG. 5A, one first nozzle group 401GX and one first outlet group 402GX are alternately arranged in the second direction Y. Four first nozzle groups 401 GX are arranged in the second direction Y. Each first nozzle group 401 GX includes 11 first nozzles 401X. Four first inlet channels 403X extending in the first direction X are arranged in the second direction Y. Five first outlet channels 404X extending in the first direction X are arranged in the second direction Y. In FIG. 5A, the number of first nozzles 401X is 11×4 = 44. Referring to FIG. 5B, two first nozzle groups 401GX and one first outlet group 402GX are alternately arranged in the second direction Y. The number of first nozzle groups 401GX is 6. Accordingly, in FIG. 5B, the number of first nozzles 401X is 11×6 = 66. Referring to FIG. 5C, three first nozzle groups 401GX and one first outlet group 402GX are alternately arranged in the first direction X. The number of first nozzle groups 401GX is 6. Accordingly, in FIG. 5C, the number of first nozzles 401X is 11×6 = 66.

The number of first nozzles that may be located in the same arrangement area in FIGS. 4A to 4C and 5A to 5C is summarized in Table 1. Referring to Table 1, a larger number of nozzles may be located in the same arrangement area in an arrangement type in which the first inlet channel 403 and the first outlet channel 404 are non-parallel to each other. Accordingly, higher cooling efficiency may be achieved.

**Table 1**

| Arrangement type of a first inlet channel and a first outlet channel | Combination of (number of first nozzle columns-number of first outlet groups) | | |
|---|---|---|---|
| | (1-1) combination | (2-1) combination | (3-1) combination |
| Intersecting arrangement | 54 | 72 | 81 |
| Parallel arrangement | 44 | 66 | 66 |

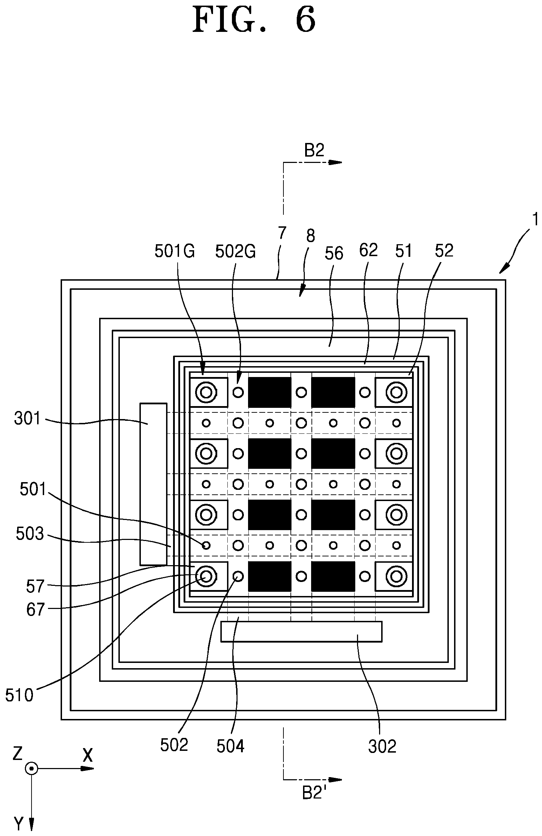

FIG. 6 is a cross-sectional view taken along line A2-A2' of FIG. 1, illustrating an example of an arrangement type of a plurality of second nozzles 501, a plurality of second outlets 502, a plurality of second inlet channels 503, a plurality of second outlet channels 504, and a plurality of TLVs 510. FIG. 7 is a cross-sectional view taken along a line B2-B2' of FIG. 6. In FIG. 7, the semiconductor chip 2 is not shown.

Referring to FIGS. 1, 6, and 7, the second shower block 5 may include the plurality of second inlet channels 503 through which a cooling liquid is supplied to the plurality of second nozzles 501 and the plurality of second outlet channels 504 connected to the plurality of second outlets 502. The plurality of second inlet channels 503 and the plurality of second outlet channels 504 are located at different heights in the second shower block 5 from each other. For example, the second shower block 5 may include a plurality of second block layers stacked on each other, and the plurality of second inlet channels 503 and the plurality of second outlet channels 504 may be formed in different block layers from among the plurality of second block layers. In other words, the plurality of second inlet channels 503 may be formed in one of the plurality of second block layers, and the plurality of second outlet channels 504 may be formed in a second block layer different from the second block layer in which the plurality of second inlet channels 503 are formed from among the plurality of second block layers. Accordingly, the plurality of second inlet channels 503 and the plurality of second outlet channels 504 may not interfere with each other or may not be connected to each other.

In an embodiment, referring to FIG. 1, the plurality of second block layers of the second shower block 5 may include a second gap layer 51, a second nozzle layer 52, a second outlet channel layer 53, a second inlet channel layer 54, and a base layer 55 sequentially stacked from a side close to the semiconductor chip 2 to a side far from the semiconductor chip 2. The plurality of second block layers may further include a side sealing layer 56. The plurality of second nozzles 501 and the plurality of second outlets 502 are provided in the second nozzle layer 52. The second gap layer 51 is located between the second nozzle layer 52 and the semiconductor chip 2 to separate the second nozzle layer 52 from the semiconductor chip 2. Accordingly, the lower cavity 312 is formed between the semiconductor chip 2 and the second shower block 5. The upper cavity 311 and the lower cavity 312 constitute the cavity 310. The side sealing layer 56 is located on the second gap layer 51. A thickness of the side sealing layer 56 may be equal to or greater than a thickness of the semiconductor chip 2. The side sealing layer 56 is located parallel to the semiconductor chip 2. The side sealing layer 56 may have a hollow plate shape that allows the semiconductor chip 2 to be accommodated in a central portion of the side sealing layer 56. The side sealing layer 56 forms a side wall of the cavity 310. The side sealing layer 56 faces the first gap layer 41 of the first shower block 4. An outer sealing adhesive member 68 (FIG. 1) is located between the side sealing layer 56 and the first gap layer 41 of the first shower block 4. The first shower block 4 and the second shower block 5 are adhered to each other by the outer sealing adhesive member 68. The outer sealing adhesive member 68 may have a closed band shape located near an outer edge of the side sealing layer 56. The outer sealing adhesive member 68 prevents a cooling liquid from leaking out of the cavity 310.

The second outlet channel layer 53 is located under the second nozzle layer 52. The plurality of second outlet channels 504 are provided in the second outlet channel layer 53. The plurality of second outlets 502 communicate with the plurality of second outlet channels 504. The second inlet channel layer 54 is located under the second outlet channel layer 53. The plurality of second inlet channels 503 are provided in the second inlet channel layer 54. The plurality of second nozzles 501 pass through the second outlet channel layer 53 without overlapping with the plurality of second outlet channels 504 to communicate with the plurality of second inlet channels 503. The base layer 55 is located under the second inlet channel layer 54 to cover the plurality of second inlet channels 503. Accordingly, a structure in which the plurality of second inlet channels 503 and the plurality of second outlet channels 504 are located at different heights in the second shower block 5 may be implemented.

The second shower block 5 is adhered to a bottom surface of the semiconductor chip 2 by a second inner sealing adhesive member 62 (FIG. 1). The second inner sealing adhesive member 62 is located between the second gap layer 51 and the bottom surface of the semiconductor chip 2. The second inner sealing adhesive member 62 may have a closed band shape located near an outer edge of the semiconductor chip 2, as shown in FIG. 6. The second inner sealing adhesive member 62 prevents a cooling liquid from leaking out of the cavity 310. The interval 501H (see FIG. 2) between the outlet of the second nozzle 501 and the bottom surface of the semiconductor chip 2 may be determined by a thickness of the second gap layer 51 and a thickness of the second inner sealing adhesive member 62.

The plurality of second block layers of the second shower block 5 may be formed of, for example, silicon.

In an embodiment, referring to FIG. 6, the plurality of second inlet channels 503 are non-parallel to the plurality of second outlet channels 504. For example, the plurality of second inlet channels 503 may be perpendicular to the plurality of second outlet channels 504. An extending direction of the plurality of second inlet channels 503 may be the same as an extending direction of the plurality of first inlet channels 403. An extending direction of the plurality of second outlet channels 504 may be the same as an extending direction of the plurality of first outlet channels 404. Such a structure enables an inlet manifold 301 and an outlet manifold 320 to be easily arranged as described below.

Referring to FIGS. 6 and 7, the semiconductor device 1 according to an embodiment may include a plurality of TLVs 510 arranged to electrically connect the semiconductor chip 2 to the printed circuit board 7. The plurality of TLVs 510 are provided in the second shower block 5. The TLV 510 has a via shape passing through the second shower block 5, and has a structure in which an electrically conductive material is located inside the via. The plurality of TLVs 510 are an example of an electrical connection structure for electrically connecting the semiconductor chip 2 to the printed circuit board 7, and a type of an electrical connection structure is not limited to the TLVs 510.

For example, the second shower block 5 may include at least one contact layer 57 on the second nozzle layer 52. A contact pad 511 contacting the semiconductor chip 2 may be provided on a top surface of the contact layer 57. A sealing member 67 seals the contact pad 511 to not contact a cooling liquid. The TLV 510 passes through the contact layer 57, and an upper end of the TLV 510 contacts the contact pad 511. An upper connection pad 512 with which the other end of the TLV 510 is in contact is provided in the base layer 55 of the second shower block 5. A lower connection pad 513 electrically connected to the upper connection pad 512 is provided on a bottom surface of the base layer 55. The lower connection pad 513 is electrically connected to the printed circuit board 7 by, for example, a solder ball 514. Accordingly, the semiconductor chip 2 may be electrically connected to the printed circuit board 7.

Referring to FIG. 6, for example, the plurality of second nozzles 501 may be two-dimensionally arranged on a horizontal plane of the second nozzle layer 52. The plurality of second outlets 502 may be two-dimensionally arranged on the horizontal plane so as to not overlap with the plurality of second nozzles 501. The plurality of TLVs 510 may be two-dimensionally arranged so as to not overlap with the plurality of second nozzles 501 and the plurality of second outlets 502.

In an embodiment, the plurality of second nozzles 501 and the plurality of TLVs 510 may be divided into a plurality of nozzle-via groups 501G. Each nozzle-via group 501G may include a plurality of second nozzles 501 arranged from each other in the second direction Y and a plurality of TLVs 510 located between the plurality of second nozzles 501. The plurality of nozzle-via groups 501G are arranged from each other in the first direction X. "When the second nozzle 501 and the TLV 510 are alternately arranged in the second direction Y", it does not mean only a case where one second nozzle 501 and one TLV 510 are alternately arranged in the second direction Y as shown in FIG. 6 but also includes a case where, for example, two or more second nozzles 501 and one or more TLVs 510 are alternately arranged in the second direction Y. An arrangement type of the second nozzle 501 and the TLV 510 in the second direction Y may be regular or irregular.

The plurality of second outlets 502 may be divided into a plurality of second outlet groups 502G. Each second outlet group 502G includes a plurality of second outlets 502 arranged from each in the second direction Y. The plurality of second outlet groups 502G are arranged from each other in the first direction X. The plurality of second outlet groups 502G are located between the plurality of nozzle-via groups 501G. That is, the nozzle-via group 501G and the second outlet group 502G are alternately arranged in the first direction X. "When the nozzle-via group 501G and the second outlet group 502G are alternately arranged in the first direction X", it does not mean only a case where one nozzle-via group 501G and one second outlet group 502G are alternately arranged in the first direction X as shown in FIG. 6 but also includes a case where, for example, two or more nozzle-via groups 501G and one or more second outlet groups 502G are alternately arranged in the first direction X. An arrangement type of the nozzle-via group 501G and the second outlet group 502G in the first direction X may be regular or irregular.

For example, the plurality of second inlet channels 503 may extend in the first direction X. The plurality of second inlet channels 503 may be arranged from each other in the second direction Y. Each second inlet channel 503 is connected to the second nozzles 501 of the plurality of nozzle-via groups 501G aligned in the first direction X (e.g., a corresponding one of the plurality of nozzle-via groups 501G). The plurality of second outlet channels 504 may extend in a direction non-parallel to the plurality of second inlet channels 503, for example, in the second direction Y. The plurality of second outlet channels 504 may be arranged from each other in the first direction X. Because the plurality of second inlet channels 503 and the plurality of second outlet channels 504 are located at different heights from each other, the plurality of second inlet channels 503 and the plurality of second outlet channels 504 may be arranged non-parallel to each other (e.g., may be arranged perpendicular to each other).

Such an arrangement type in which "the plurality of second inlet channels 503 and the plurality of second outlet channels 504 are arranged non-parallel to each other" allows as many second nozzles 501 as possible to face a bottom surface of the semiconductor chip 2, which is a heat exchange surface. Accordingly, the semiconductor chip 2 may be effectively cooled. This may be understood by respectively replacing the plurality of first nozzles 401, the plurality of first nozzle groups 401G, the plurality of first outlets 402, the plurality of first outlet groups 402G, the plurality of first inlet channels 403, and the plurality of first outlet channels 404 in the description of FIGS. 4A to 4C with the plurality of second nozzles 501, the plurality of nozzle-via groups 501G, the plurality of second outlets 502, the plurality of second outlet groups 502G, the plurality of second inlet channels 503, and the plurality of second outlet channels 504.

Referring to FIGS. 1 and 3, the semiconductor device 1 according to an embodiment may include the inlet manifold 301. A plurality of first inlet channels 403 and a plurality of second inlet channels 503 branch from the inlet manifold 301. The inlet manifold 301 is provided in the cooling block 3 to communicate with the outside. A cooling liquid may be supplied to the plurality of first inlet channels 403 and the plurality of second inlet channels 503 through the inlet manifold 301. In an embodiment, the inlet manifold 301 may be formed by penetrating from the first inlet channel layer 44 of the first shower block 4 to the second inlet channel layer 54 of the second shower block 5 in the third direction Z. A sealing member 63 (FIG. 1) for sealing the inlet manifold 301 from the outside is provided between the side sealing layer 56 and the first gap layer 41. Because the plurality of first inlet channels 403 and the plurality of second inlet channels 503 extend in the same direction (e.g., the first direction X) the inlet manifold 301 may be provided near a side edge of the cooling block 3 in the first direction X. Accordingly, the inlet manifold 301 may be easily arranged in the cooling block 3, and the inlet manifold 301 having a simple structure from which the plurality of the first inlet channels 403 and the plurality of second inlet channels 503 branch may be implemented.

The inlet manifold 301 communicates with the outside to receive a cooling liquid. In an embodiment, the inlet manifold 301 may pass through the first shower block 4 to communicate with the outside. Referring to FIG. 1, as described above, the semiconductor device 1 according to an embodiment may include the housing 8 covering the cooling block 3. A cooling liquid supply port 86 for supplying a cooling liquid may be provided on the upper wall 81 of the housing 8. The inlet manifold 301 may pass through the first shower block 4 and may be connected to the cooling liquid supply port 86.

Referring to FIGS. 3 and 7, the semiconductor device 1 according to an embodiment may include the outlet manifold 302. The plurality of first outlet channels 404 and the plurality of second outlet channels 504 are joined to the outlet manifold 302. The outlet manifold 302 is provided in the cooling block 3 to communicate with the outside. In an embodiment, the outlet manifold 302 may be formed by penetrating from the first outlet channel layer 43 of the first shower block 4 to the second outlet channel layer 53 of the second shower block 5 in the third direction Z. A sealing member 66 for sealing the outlet manifold 302 from the outside is provided between the side sealing layer 56 and the first gap layer 41. Because the plurality of first outlet channels 404 and the plurality of second outlet channels 504 extend in the same direction (e.g., the second direction Y) the outlet manifold 302 may be provided near a side edge of the cooling block 3 in the second direction Y. Accordingly, the outlet manifold 302 may be easily arranged in the cooling block 3, and the outlet manifold 302 having a simple structure to which the plurality of first outlet channels 404 and the plurality of second outlet channels 504 are joined may be implemented.

The outlet manifold 302 communicates with the outside to discharge a cooling liquid. In an embodiment, the outlet manifold 302 may pass through the first shower block 4 to communicate with the outside. Referring to FIG. 7, a cooling liquid discharge port 87 for discharging a cooling liquid may be provided on the upper wall 81 of the housing 8. The outlet manifold 302 may pass through the first shower block 4 and may be connected to the cooling liquid discharge port 87.

Referring to FIG. 3, the cooling liquid supply port 86 is connected to a pump 91. When used in a two-phase cooling method using latent heat in boiling a cooling liquid, a pre-heater for heating a cooling liquid to raise a temperature of the cooling liquid to near a saturation temperature may be located between the cooling liquid supply port 86 and the pump 91 or at a front end of the pump 91. The cooling liquid discharge port 87 may be connected to a condenser 92 to phase-change cooling gas into a cooling liquid. The pump 91 and the condenser 92 may be connected to each other directly or with a cooling liquid receiving tank or the pre-heater therebetween.

A cooling operation of the semiconductor device 1 according to an embodiment will be described below with reference to FIGS. 1 to 7. A cooling liquid is supplied to the inlet manifold 301 through the cooling liquid supply port 86 by the pump 91. In an embodiment, the cooling liquid may be a polar cooling liquid (e.g., water). In an embodiment, the cooling liquid may be a dielectric cooling liquid.

The cooling liquid is distributed to the plurality of first inlet channels 403 through the inlet manifold 301 and is sprayed into the cavity 310 through the plurality of first nozzles 401. Accordingly, an impingement jet of the cooling liquid is provided to a top surface of the semiconductor chip 2. The impingement jet of the cooling liquid hits the top surface of the semiconductor chip 2 and then flows upward. A temperature of the cooling liquid may increase through heat exchange with the semiconductor chip 2, and the cooling liquid may be partially vaporized to become cooling gas. The cooling liquid and the cooling gas exit the cavity 310 through the plurality of first outlets 402, flow along the plurality of first outlet channels 404, and are joined in the outlet manifold 302. Likewise, a cooling liquid is distributed to the plurality of second inlet channels 503 through the inlet manifold 301 and is sprayed into the cavity 310 from the plurality of second nozzles 501. Accordingly, an impingement jet of the cooling liquid is provided to a bottom surface of the semiconductor chip 2. The impingement jet of the cooling liquid hits the bottom surface of the semiconductor chip 2 and then flows downward. A temperature of the cooling liquid may increase through heat exchange with the semiconductor chip 2, and the cooling liquid may be partially vaporized to become cooling gas. The cooling liquid and the cooling gas exit the cavity 310 through the plurality of second outlets 502, flow along the plurality of second outlet channels 504, and are joined in the outlet manifold 302. The cooling liquid and the cooling gas are discharged from the semiconductor device 1 through the cooling liquid discharge port 87 and are supplied back to the pump 91 through the condenser 92. As such, because a cooling liquid impingement jet is provided to the top surface and the bottom surface of the semiconductor chip 2, the semiconductor chip 2 may be effectively cooled. Also, in the second shower block 5, interference between the second inlet channels 503 and the second outlet channels 504 and the plurality of TLVs 510 is avoided. Accordingly, in a state where electrical connection between the semiconductor chip 2 and the printed circuit board 7 is maintained, a large amount of cooling liquid may be supplied as an impingement jet to the top surface and the bottom surface of the semiconductor chip 2.

Although one inlet manifold 301 and one outlet manifold 302 are provided in the cooling block 3 in the above embodiment, embodiments of the present disclosure are not limited thereto. According to embodiments, the number of at least one from among the inlet manifold 301 and the outlet manifold 302 may be two or more. Although one cavity 310 is provided in the cooling block 3 in the above embodiment, embodiments of the present disclosure are not limited thereto. According to embodiments, two or more cavities may be provided in the cooling block 3. In this case, the two or more cavities may be arranged in a horizontal direction (e.g., the first direction X and/or the second direction Y).

FIG. 8 is a schematic cross-sectional view illustrating a semiconductor device 1a, according to an embodiment. FIG. 8 is a view corresponding to FIG. 7. The semiconductor device 1a of FIG. 8 is different from the semiconductor device 1 of FIGS. 1 to 7 in that the semiconductor device 1a includes a plurality of semiconductor chips 2. Hereinafter, elements having the same functions are denoted by the same reference numerals, a repeated description thereof may be omitted, and a difference will be mainly described.

Referring to FIG. 8, the plurality of semiconductor chips 2 are located on a cooling block 3a. The plurality of semiconductor chips 2 are stacked in a thickness direction (e.g., the third direction Z) to form the semiconductor chip stack 2CS. The cooling block 3a includes the first shower block 4 and a second shower block 5a. The second shower block 5a is different from the second shower block 5 in that the second shower block 5a includes a side sealing layer 56a thicker than the side sealing layer 56 of FIGS. 1 to 7 to form a second cavity 310a having a thickness large enough to accommodate the semiconductor chip stack 2CS. A first inner sealing adhesive member 61 is located between the first gap layer 41 of the first shower block 4 and a semiconductor chip 2U located at an uppermost position from among the plurality of semiconductor chips 2. The plurality of semiconductor chips 2 are electrically connected to each other by a plurality of interlayer electrical connection structures (e.g., micro solder balls 515). A contact pad 511 is electrically connected to a semiconductor chip 2L located at a lowermost position from among the plurality of semiconductor chips 2. Accordingly, the plurality of semiconductor chips 2 may be electrically connected to the printed circuit board 7 through the TLV 510.

A cooling liquid supplied to the inlet manifold 301 through the cooling liquid supply port 86 due to pressure of the pump 91 is distributed to the plurality of first inlet channels 403 and the plurality of second inlet channels 503 and is sprayed into the cavity 310 from the plurality of first nozzles 401 and the plurality of second nozzles 501. Accordingly, an impingement jet of the cooling liquid is provided to a top surface of the semiconductor chip 2U and a bottom surface of the semiconductor chip 2L. The impingement jet of the cooling liquid hits the top surface of the semiconductor chip 2U and the bottom surface of the semiconductor chip 2L to cool the plurality of semiconductor chips 2 and then is discharged from the cavity 310 from the plurality of first outlets 402 and the plurality of second outlets 502. One or more semiconductor chips 2 located in the middle are not in direct contact with the impingement jet of the cooling liquid, but are cooled by discharging heat by conduction to the semiconductor chip 2U and the semiconductor chip 2L through the micro solder balls 515. The cooling liquid and/or cooling gas flows along the plurality of first outlet channels 404 and the plurality of second outlet channels 504 to be joined in the outlet manifold 302, and is discharged to the condenser 92 through the cooling liquid discharge port 87.

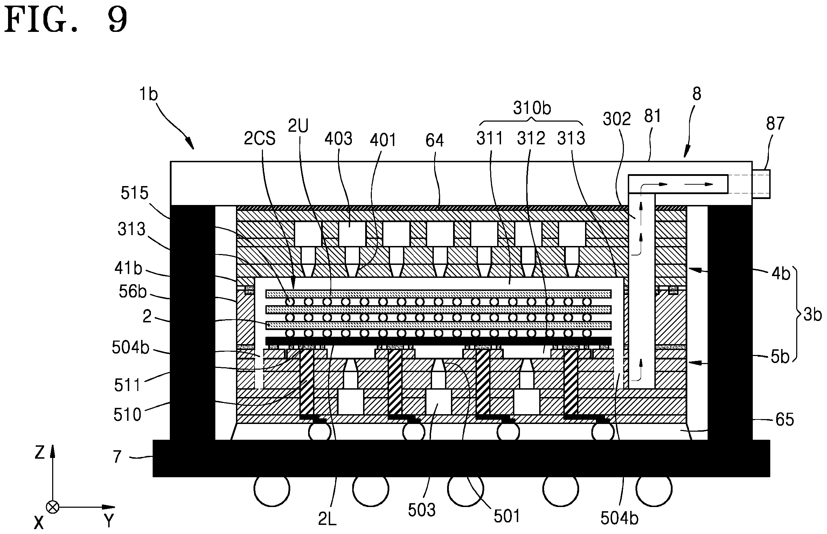

FIG. 9 is a schematic cross-sectional view illustrating a semiconductor device 1b, according to an embodiment. FIG. 9 is a view corresponding to FIG. 7. The semiconductor device 1b of FIG. 9 is different from the semiconductor device 1a of FIG. 8 in that the semiconductor device 1b includes a cavity 310b in which the upper cavity 311 and the lower cavity 312 communicate with each other. Hereinafter, elements having the same functions are denoted by the same reference numerals, a repeated description may be omitted, and a difference will be mainly described.

Referring to FIG. 9, a cooling block 3b includes the cavity 310b. The cavity 310b includes the upper cavity 311, the lower cavity 312, and a connecting portion 313 that connects the upper cavity 311 to the lower cavity 312. The connecting portion 313 may extend along an outer edge of the cavity 310b in a thickness direction of the cavity 310b (e.g., the third direction Z).

In an embodiment, a side sealing layer 56b of the second shower block 5b is different from the side sealing layer 56a of FIG. 8 in that the side sealing layer 56b is spaced apart from side surfaces of the plurality of semiconductor chips 2. To form the connecting portion 313, a first gap layer 41b of the first shower block 4b is different from the first gap layer 41 of the first shower block 4 of FIG. 8 in that the first gap layer 41b is parallel to the side sealing layer 56b in a vertical direction. Accordingly, the first inner sealing adhesive member 61 located between the first gap layer 41b and the semiconductor chip 2U is omitted, and the connecting portion 313 for connecting the upper cavity 311 to the lower cavity 312 is formed between the side sealing layer 56b of the second shower block 5b and side surfaces of the plurality of semiconductor chips 2.

A cooling liquid supplied to the inlet manifold 301 through the cooling liquid supply port 86 due to pressure of the pump 91 is distributed to the plurality of first inlet channels 403 and the plurality of second inlet channels 503 and is sprayed into the cavity 310 from the plurality of first nozzles 401 and the plurality of second nozzles 501. Accordingly, an impingement jet of the cooling liquid is provided to the top surface of the semiconductor chip 2U and the bottom surface of the semiconductor chip 2L. The impingement jet of the cooling liquid hits the top surface of the semiconductor chip 2U and the bottom surface of the semiconductor chip 2L to cool the semiconductor chip 2U and the semiconductor chip 2L. At least one semiconductor chip 2 between the semiconductor chip 2U and the semiconductor chip 2L is not in direct contact with the impingement jet of the cooling liquid, but is cooled by discharging heat by conduction to the semiconductor chip 2U and the semiconductor chip 2L through the micro solder balls 515.

A part of the impingement jet of the cooling liquid hitting the top surface of the semiconductor chip 2U flows to the connecting portion 313. When a polar cooling liquid is used, the micro solder balls 515 are protected by an underfill. Accordingly, although the cooling liquid does not flow between the plurality of semiconductor chips 2, the side surfaces of the plurality of semiconductor chips 2 may be additionally cooled. When a dielectric cooling liquid is used, the underfill may be omitted. Accordingly, the cooling liquid introduced through the connecting portion 313 may be introduced between the plurality of semiconductor chips 2 to effectively cool the plurality of semiconductor chips 2 through heat exchange with the top surface and the bottom surface of the plurality of semiconductor chips 2.

The cooling liquid and/or cooling gas cools the plurality of semiconductor chips 2 and then is discharged from the cavity 310b through the plurality of first outlets 402 and the plurality of second outlets 502. The cooling liquid and/or the cooling gas flows along the plurality of first outlet channels 404 and the plurality of second outlet channels 504 to be joined in the outlet manifold 302, and is discharged to the condenser 92 through the cooling liquid discharge port 87.

As marked by a dashed line in FIG. 9, a second outlet channel 504b communicating with the connecting portion 313 may be further provided in the second shower block 5b. The cooling liquid flowing along the connecting portion 313 may be discharged to the outlet manifold 302 through the second outlet channel 504b.

The connecting portion 313 and the second outlet channel 504b of FIG. 9 may be applied to embodiments of the semiconductor device described above or below.

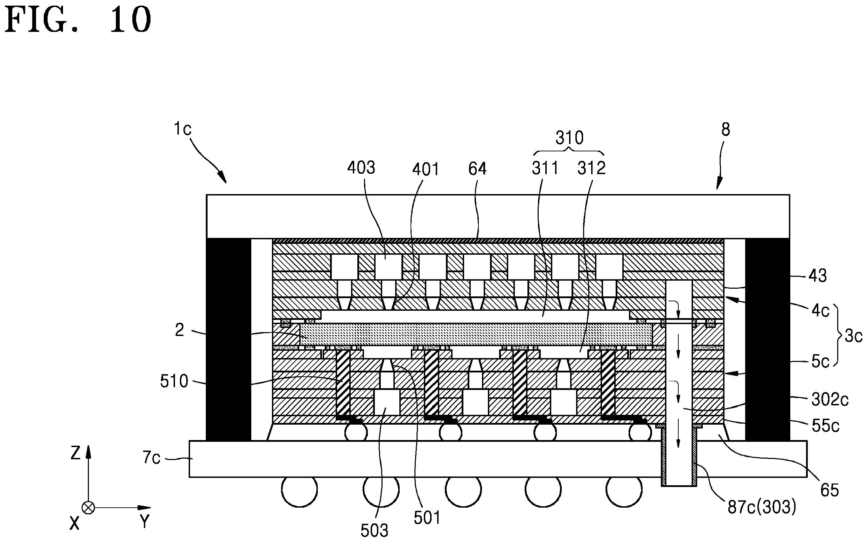

FIG. 10 is a schematic cross-sectional view illustrating a semiconductor device 1c, according to an embodiment. FIG. 10 is a view corresponding to FIG. 7. The semiconductor device 1c of FIG. 10 is different from the semiconductor device 1 of FIGS. 1 to 7 in that an outlet manifold 302c passes through a second shower block 5c to communicate with the outside. Hereinafter, elements having the same functions are denoted by the same reference numerals, a repeated description thereof may be omitted, and a difference will be mainly described.

Referring to FIG. 10, a cooling block 3c includes a first shower block 4c and the second shower block 5c. The first shower block 4c is different from the first shower block 4 in that the outlet manifold 302c is formed up to the first outlet channel layer 43. The outlet manifold 302c passes through the second shower block 5c. That is, the outlet manifold 302c extends downward from the first outlet channel layer 43 of the first shower block 4c and entirely passes through the second shower block 5c to a base layer 55c. An opening of the outlet manifold 302c formed in the base layer 55c is connected to a cooling liquid discharge port 87c. The cooling liquid discharge port 87c may have a structure for discharging a cooling liquid downward. For example, the cooling liquid discharge port 87c may be implemented by a pipe 303 connected to the opening of the outlet manifold 302c formed in the base layer 55 and passing through a printed circuit board 7c.

According to this configuration, a cooling liquid and/or cooling gas cooling the plurality of semiconductor chips 2 and then discharged from the cavity 310 and joined in the outlet manifold 302c may be naturally discharged through the cooling liquid discharge port 87c by gravity. Accordingly, the pump 91 may operate at a relatively low pumping pressure, thereby saving energy.

The outlet manifold 302c of FIG. 10 may be applied to embodiments of the semiconductor device described above or below.

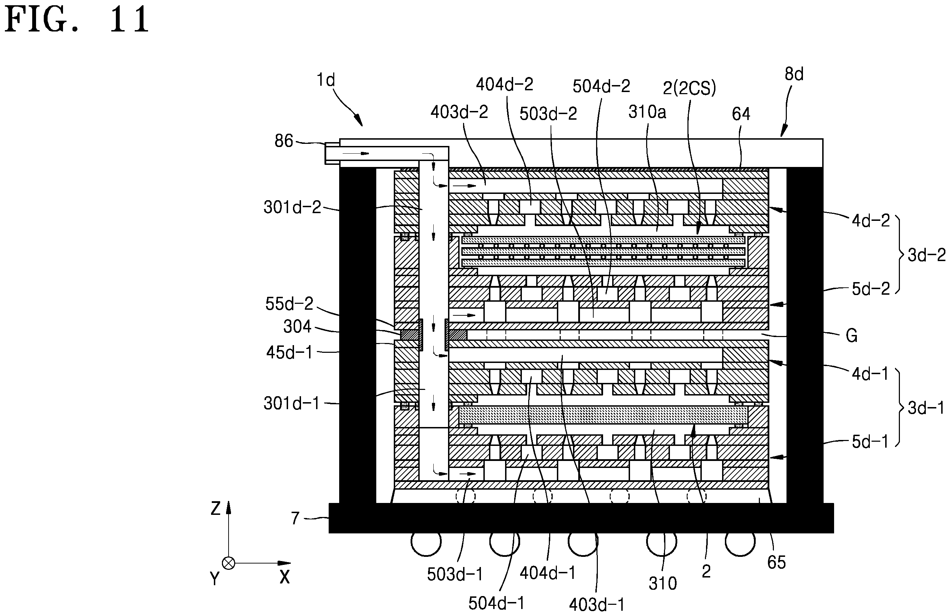

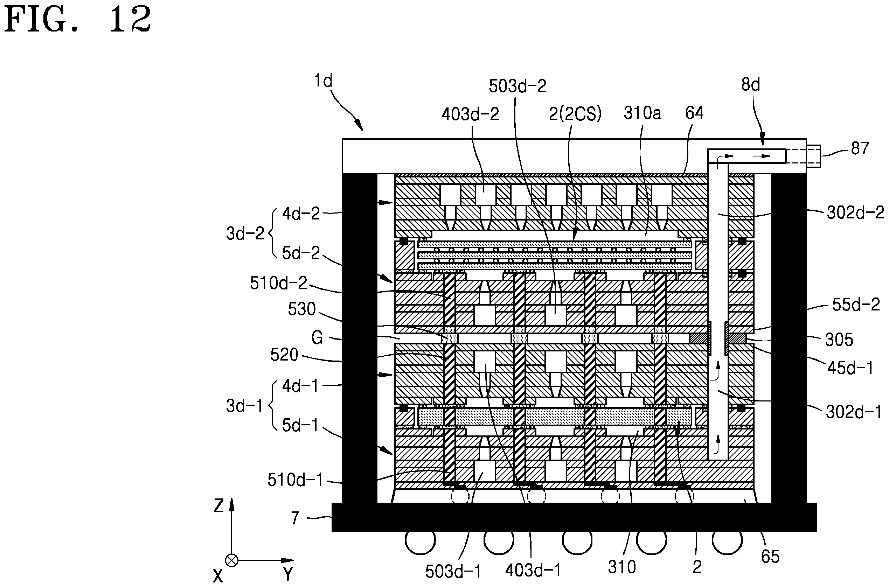

FIGS. 11 and 12 are schematic cross-sectional views illustrating a semiconductor device 1d, according to an embodiment. FIG. 11 is a view corresponding to FIG. 1. FIG. 12 is a view corresponding to FIG. 7. The semiconductor device 1d of the present embodiment has a structure in which the cooling block 3 of the semiconductor device 1 of FIGS. 1 to 7 and the cooling block 3a of the semiconductor device 1a of FIG. 8 are stacked. Hereinafter, elements having the same functions as those already described in the above embodiments are denoted by the same reference numerals, a repeated description thereof may be omitted, and a difference will be mainly described.

Referring to FIGS. 11 and 12, the semiconductor device 1d includes a first cooling block 3d-1 and a second cooling block 3d-2. The cavity 310 (e.g., a first cavity) is provided in the first cooling block 3d-1, and the semiconductor chip 2 (e.g., a first semiconductor chip) is located in the cavity 310. The second cavity 310a is provided in the second block 3d-2, and the semiconductor chip stack 2CS (e.g., second semiconductor chips) is located in the second cavity 310a. The first cooling block 3d-1 is supported on the printed circuit board 7 by the adhesive layer 65, and the second cooling block 3d-2 is stacked on the first cooling block 3d-1. The second cooling block 3d-2 may be stacked on the first cooling block 3d-1 with an interval G therebetween. A housing 8d covers the first cooling blocks 3d-1 and the second cooling block 3d-2 and is supported on the printed circuit board 7. The description of the cooling block 3 applies to the first cooling block 3d-1, unless contradictory. The description of the cooling block 3a of FIG. 8 applies to the second cooling block 3d-2, unless contradictory. That is, the description of the first shower block 4 and the second shower block 5 of the first cooling block 3 applies to a first shower block 4d-1 and a second shower block 5d-1 of the first cooling block 3d-1, and the description of the first shower block 4a and the second shower block 5a of the cooling block 3a applies to a first shower block 4d-2 and a second shower block 5d-2 of the second cooling block 3d-2. Accordingly, the description of the first inlet channel 403, the first outlet channel 404, the second inlet channel 503, the second outlet channel 504, and the TLV 510 applies to a first inlet channel 403d-1, a first outlet channel 404d-1, a second inlet channel 503d-1, a second outlet channel 504d-1, and a first TLV 510d-1 of the first cooling block 3d-1, and the description of the first inlet channel 403, the first outlet channel 404, the second inlet channel 503, the second outlet channel 504, and the TLV 510 applies to a first inlet channel 403d-2, a first outlet channel 404d-2, a second inlet channel 503d-2, a second outlet channel 504d-2, and a second TLV 510d-2 of the second cooling block 3d-2.

Referring to FIG. 11, the first cooling block 3d-1 includes a first inlet manifold 301d-1 from which a plurality of first inlet channels 403d-1 and a plurality of second inlet channels 503d-1 branch. The second cooling block 3d-2 includes a second inlet manifold 301d-2 to which a plurality of first inlet channels 403d-2 and a plurality of second inlet channels 503d-2 are joined. The first inlet manifold 301d-1 and the second inlet manifold 301d-2 are connected to each other to communicate with the outside. In an embodiment, the first inlet manifold 301d-1 extends upward along the first shower block 4d-1 and passes through a first cover layer 45d-1. The second inlet manifold 301d-2 extends downward along the second shower block 5d-2 and passes through a base layer 55d-2. An upper opening of the first inlet manifold 301d-1 and a lower opening of the second inlet manifold 301d-2 face each other with the interval G therebetween. A connection member 304 for connecting the upper opening of the first inlet manifold 301d-1 to the lower opening of the second inlet manifold 301d-2 is located in the interval G. The second inlet manifold 301d-2 extends upward along the first shower block 4d-2 of the second cooling block 3d-2 and is connected to the cooling liquid supply port 86 provided in a housing 8d. Accordingly, the first inlet manifold 301d-1 and the second inlet manifold 301d-2 are connected to each other to communicate with the outside.

Referring to FIG. 12, the first cooling block 3d-1 includes a first outlet manifold 302d-1 from which a plurality of first outlet channels 404d-1 and a plurality of second outlet channels 504d-1 branch. The second cooling block 3d-2 includes a second outlet manifold 302d-2 to which a plurality of first outlet channels 404d-2 and a plurality of second outlet channels 504d-2 are joined. The first outlet manifold 302d-1 and the second outlet manifold 302d-2 are connected to each other to communicate with the outside. In an embodiment, the first outlet manifold 302d-1 extends upward along the first shower block 4d-1 of the first cooling block 3d-1 and passes through the first cover layer 45d-1. The second outlet manifold 302d-2 extends downward along the second shower block 5d-2 of the second cooling block 3d-2 and passes through the base layer 55d-2. An upper opening of the first outlet manifold 302d-1 and a lower opening of the second outlet manifold 302d-2 face each other with the interval G therebetween. A connection member 305 for connecting the upper opening of the first outlet manifold 302d-1 to the lower opening of the second outlet manifold 302d-2 is located in the interval G. The second outlet manifold 302d-2 extends upward along the first shower block 4d-2 of the second cooling block 3d-2 and is connected to the cooling liquid discharge port 87 provided in the housing 8d. Accordingly, the first outlet manifold 302d-1 and the second outlet manifold 302d-2 are connected to each other to communicate with the outside.

Referring to FIG. 12, the first cooling block 3d-1 includes a plurality of first TLVs 510d-1. The second cooling block 3d-2 includes a plurality of second TLVs 510d-2. The plurality of first TLVs 510d-1 are electrically connected to the printed circuit board 7. The plurality of second TLVs 510d-2 may be connected to the printed circuit board 7 by the plurality of first TLVs 510d-1. For example, a plurality of third TLVs 520 are provided in the first shower block 4d-1 of the first cooling block 3d-1. Lower ends of the plurality of third TLVs 520 may be electrically connected to the semiconductor chip 2 located in the cavity 310 of the first cooling block 3d-1, and a connection structure between the TLV 510 and the semiconductor chip 2 described with reference to FIG. 7 may be applied to this connection structure. Upper ends of the plurality of third TLVs 520 are exposed to the interval G through the first cover layer 45d-1. Through-holes through which lower ends of the plurality of second TLVs 510d-2 are exposed are formed in the base layer 55d-2 of the second cooling block 3d-2. A connection member 530 for electrically connecting the upper ends of the plurality of third TLVs 520 to the lower ends of the plurality of second TLVs 510d-2 may be provided in the interval G. Accordingly, the semiconductor chip stack 2CS and the semiconductor chip 2 may be electrically connected to the printed circuit board 7.

A cooling liquid supplied to the second inlet manifold 301d-2 through the cooling liquid supply port 86 due to pressure of the pump 91 is distributed to the plurality of first inlet channels 403d-2 and the plurality of second inlet channels 503d-2 of the second cooling block 3d-2 and is sprayed into the second cavity 310a. Accordingly, an impingement jet of the cooling liquid is provided to a top surface of the semiconductor chip 2U and a bottom surface of the semiconductor chip 2L. The impingement jet of the cooling liquid hits the top surface of the semiconductor chip 2U and the bottom surface of the semiconductor chip 2L to cool the plurality of semiconductor chips 2. One or more semiconductor chips 2 between the semiconductor chip 2U and the semiconductor chip 2L are not in direct contact with the cooling liquid impingement jet, but are cooled by discharging heat by conduction to the semiconductor chip 2U and the semiconductor chip 2L through the micro solder balls 515. The cooling liquid and/or cooling gas discharged from the second cavity 310a flows along the plurality of first outlet channels 404d-2 and the plurality of second outlet channels 504d-2 of the second cooling block 3d-2 to be joined in the second outlet manifold 302d-2.

A part of the cooling liquid flowing along the second inlet manifold 301d-2 is supplied to the first inlet manifold 301d-1 through the connection member 304. The cooling liquid is distributed to the plurality of first inlet channels 403d-1 and the plurality of second inlet channels 503d-1 of the first cooling block 3d-1 and is sprayed into the cavity 310. Accordingly, the impingement jet of the cooling liquid is provided to a top surface and a bottom surface of the semiconductor chip 2. The impingement jet of the cooling liquid hits the top surface and the bottom surface of the semiconductor chip 2 to cool the semiconductor chip 2. The cooling liquid and/or cooling gas discharged from the cavity 310 flows along the plurality of first outlet channels 404d-1 and the plurality of second outlet channels 504d-1 of the first cooling block 3d-1 to be joined in the first outlet manifold 302d-1. The cooling liquid and/or the cooling gas passes through the first outlet manifold 302d-1 and the connection member 305 to be joined in the second outlet manifold 302d-2, and is discharged through the cooling liquid discharge port 87.

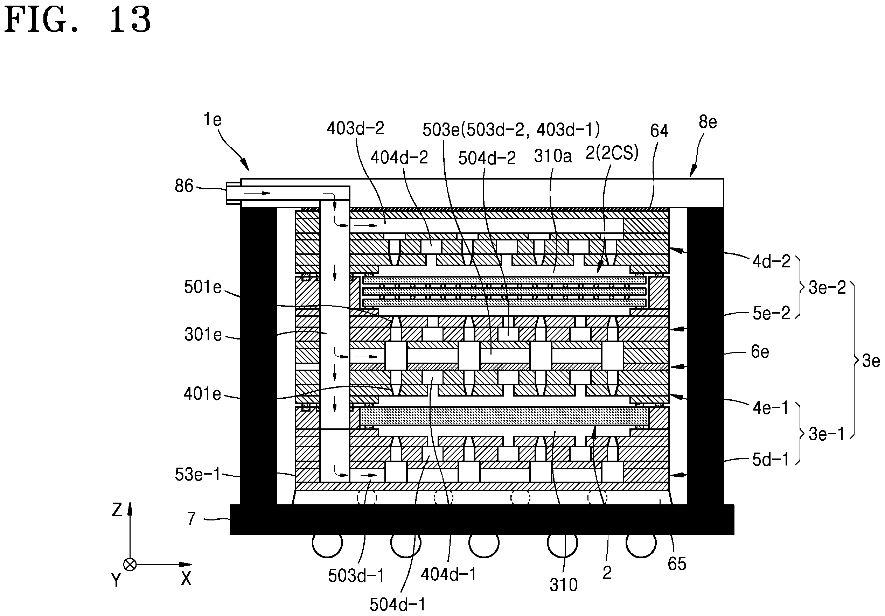

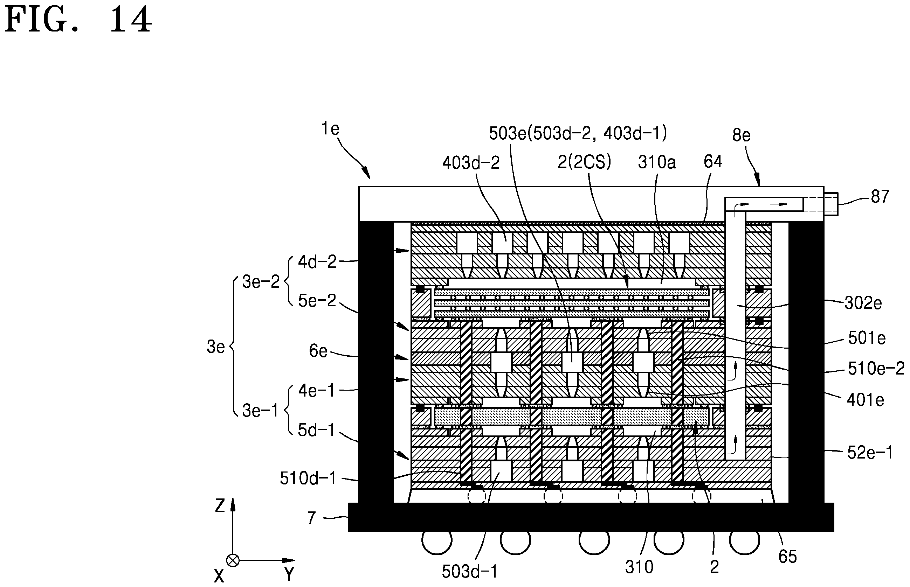

FIGS. 13 and 14 are schematic cross-sectional views illustrating a semiconductor device 1e, according to an embodiment. FIG. 13 is a view corresponding to FIG. 11. FIG. 14 is a view corresponding to FIG. 12. The semiconductor device 1e of the present embodiment is different from the semiconductor device 1d of FIGS. 1 1 and 12 in that a first inlet channel of a first cooling block and a second inlet channel of a second cooling block are combined. That is, the first inlet channel of the first cooling block is connected to a plurality of second nozzles of the second cooling block to function as the second inlet channel of the second cooling block. Hereinafter, elements having the same functions as those already described in the above embodiments are denoted by the same reference numerals, a repeated description thereof may be omitted, and a difference will be mainly described.

Referring to FIGS. 13 and 14, the semiconductor device 1e includes a cooling block 3e. The cooling block 3e may include two cavities (e.g., the cavity 310 and the second cavity 310a) located in a vertical direction from each other. The semiconductor chip 2 (e.g., a first semiconductor chip) is located in the cavity 310, and the semiconductor chip stack 2CS (e.g., second semiconductor chips) is located in the second cavity 310a.

The cooling block 3e may conceptually have a structure in which two cooling blocks, that is, a first cooling block 3e-1 and a second cooling block 3e-2, are stacked in a vertical direction, that is, in the third direction Z. The first cooling block 3e-1 includes a first shower block and a second shower block. The second shower block 3e-2 includes a first shower block and a second shower block. The second shower block of the first cooling block 3e-1 is the same as the second shower block 5d-1 of the first cooling block 3d-1 of FIGS. 11 and 12, and thus, is denoted as the second shower block 5d-1. The first shower block 4e-1 of the first cooling block 3e-1 is different from the first shower block 4d-1 of the first cooling block 3d-1 of FIGS. 11 and 12 in that the first shower block 4e-1 includes a common inlet channel 503e. The second shower block 5e-2 of the second cooling block 3e-2 is different from the second shower block 5d-2 of the second cooling block 3d-2 of FIGS. 11 and 12 in that the second shower block 5e-2 includes the common inlet channel 503e. The description of the first cooling blocks 3d-1 and the second cooling block 3d-2 of FIGS. 11 and 12 applies to the cooling block 3e, unless contradictory.

In another aspect, the cooling block 3e includes the first shower block 4d-2, the second shower block 5d-1, and a third shower block 6e located between the first shower block 4d-2 and the second shower block 5d-1. The third shower block 6e faces the first shower block 4d-2 to form the cavity 310. The third shower block 6e faces the second shower block 5d-1 to form the second cavity 310a. The third shower block 6e includes the common inlet channel 503e, a first nozzle portion 401e and a second nozzle portion 501e connected to the common inlet channel 503e to provide a jet of a cooling liquid toward the cavity 310 and the second cavity 310a, a plurality of first outlet channels 404d-1 connected to the cavity 310, and a plurality of second outlet channels 504d-2 connected to the second cavity 310a.

Referring to FIG. 13, an inlet manifold 301e is illustrated. The inlet manifold 301e has a structure in which the first inlet manifold 301d-1 and the second inlet manifold 301d-2 of FIG. 11 are combined with each other without the connection member 304. The inlet manifold 301e extends upward from a second inlet channel layer 53e-1 of the second shower block 5d-1 of the first cooling block 3e-1 and passes through the entire cooling block 3e. The inlet manifold 301e is connected to the cooling liquid supply port 86 provided in a housing 8e.

Referring to FIG. 14, an outlet manifold 302e is illustrated. The outlet manifold 302e has a structure in which the first outlet manifold 302d-1 and the second outlet manifold 302d-2 of FIG. 12 are combined with each other without the connection member 305. The outlet manifold 3021e extends upward from a second outlet channel layer 52e-1 of the second shower block 5d-1 of the first cooling block 3e-1 and passes through the entire cooling block 3e. The outlet manifold 302e is connected to the cooling liquid discharge port 87 provided in the housing 8e.

Referring to FIG. 14, the first cooling block 3e-1 includes a plurality of first TLVs 510d-1. The plurality of first TLVs 510d-1 electrically connect the semiconductor chip 2 in the cavity 310 to the printed circuit board 7. The semiconductor chip stack 2CS in the second cavity 310a may be electrically connected to the printed circuit board 7 through a plurality of second TLVs 510e-2 of the second cooling block 3e-2 and the plurality of first TLVs 510d-1. For example, the plurality of second TLVs 510e-2 of the second cooling block 3e-2 pass through the third shower block 6e, that is, the second shower block 5e-2 of the second cooling block 3e-2 and the first shower block 4e-1 of the first cooling block 3e-1. Lower ends of the plurality of second TLVs 510e-2 may be electrically connected to the semiconductor chip 2 located in the cavity 310 of the first cooling block 3e-1, and a connection structure between the TLV 510 and the semiconductor chip 2 described with reference to FIG. 7 may be applied to this connection structure. Accordingly, the semiconductor chip stack 2CS and the semiconductor chip 2 may be electrically connected to the printed circuit board 7.

A cooling liquid supplied to the inlet manifold 301e through the cooling liquid supply port 86 due to pressure of the pump 91 is distributed to the first inlet channels 403d-2 of the second cooling block 3e-2, the common inlet channels 503e, and the second inlet channels 503d-1 of the first cooling block 3e-1 and is sprayed into the cavity 310 and the second cavity 310a to cool the semiconductor chip 2 and the semiconductor chip stack 2CS. The cooling liquid and/or cooling gas discharged from the cavity 310 and the second cavity 310a is joined in the outlet manifold 302e and is discharged through the cooling liquid discharge port 87.

According to embodiments of a semiconductor device described above, high cooling efficiency may be achieved by supplying a cooling liquid onto at least two surfaces of a semiconductor chip.

Example embodiments described herein should be considered in a descriptive sense only and not for purposes of limitation. Descriptions of features or aspects within each example embodiment should typically be considered as available for other similar features or aspects in other embodiments. While one or more non-limiting example embodiments have been described with reference to the figures, it will be understood by one of ordinary skill in the art that various changes in form and details may be made therein without departing from the scope of the present disclosure.

## Claims

1. A semiconductor device comprising:
at least one semiconductor chip comprising a semiconductor integrated circuit;
at least one cooling block comprising a first shower block and a second shower block stacked on the first shower block such that the first shower block and the second shower block define a cavity in which the at least one semiconductor chip is accommodated; and
a printed circuit board, wherein the at least one cooling block is on the printed circuit board,
wherein the first shower block comprises:
a plurality of first nozzles configured to spray a cooling liquid into the cavity toward a top surface of the at least one semiconductor chip; and
a plurality of first outlets configured as a first discharge passage that receives the cooling liquid from the cavity, and
wherein the second shower block comprises:
a plurality of second nozzles configured to spray the cooling liquid into the cavity toward a bottom surface of the at least one semiconductor chip; and
a plurality of second outlets configured a second discharge passage that receives the cooling liquid from the cavity.

2. The semiconductor device of claim 1, wherein
the first shower block further comprises:
a plurality of first inlet channels that are configured to supply the cooling liquid to the plurality of first nozzles; and
a plurality of first outlet channels connected to the plurality of first outlets, and
the second shower block comprises:
a plurality of second inlet channels that are configured to supply the cooling liquid to the plurality of second nozzles; and
a plurality of second outlet channels connected to the plurality of second outlets.

3. The semiconductor device of claim 2, wherein
the first shower block further comprises a plurality of first block layers, and the plurality of first inlet channels and the plurality of first outlet channels are formed in different layers from among the plurality of first block layers,
the second shower block further comprises a plurality of second block layers, and the plurality of second inlet channels and the plurality of second outlet channels are formed in different layers from among the plurality of second block layers, and
the plurality of first inlet channels and the plurality of first outlet channels are non-parallel to each other, and optionally wherein:
the plurality of first inlet channels and the plurality of second inlet channels extend in a same direction as each other; and
the plurality of first outlet channels and the plurality of second outlet channels extend in a same direction as each other.

4. The semiconductor device of claim 2 or 3, further comprising:
an inlet manifold from which the plurality of first inlet channels and the plurality of second inlet channels branch, wherein the inlet manifold is in the at least one cooling block and communicates with an outside of the semiconductor device; and
an outlet manifold to which the plurality of first outlet channels and the plurality of second outlet channels are joined, wherein the outlet manifold is in the at least one cooling block and communicates with the outside, and optionally wherein the inlet manifold passes through the first shower block to communicate with the outside.

5. The semiconductor device of claim 4, wherein the outlet manifold passes through the first shower block to communicate with the outside.

6. The semiconductor device of claim 4, wherein the outlet manifold passes through the second shower block to communicate with the outside.

7. The semiconductor device of any preceding claim, further comprising:
a plurality of first nozzle groups each comprising a subset of the plurality of first nozzles arranged from each other in a second direction, the plurality of first nozzle groups arranged from each other in a first direction, perpendicular to the second direction; and
a plurality of first outlet groups each comprising a subset of the plurality of first outlets arranged in the second direction from each other, the plurality of first outlet groups arranged in the first direction from each other,
wherein the plurality of first outlet groups are between the plurality of first nozzle groups, and optionally wherein the first shower block further comprises:
a plurality of first inlet channels that are configured to supply the cooling liquid to the plurality of first nozzles; and
a plurality of first outlet channels connected to the plurality of first outlets,
wherein the plurality of first inlet channels extend in the first direction and are arranged in the second direction from each other, and
wherein the plurality of first outlet channels extend in the second direction and are arranged in the first direction from each other.

8. The semiconductor device of any preceding claim, wherein the second shower block is on the printed circuit board, and
wherein the semiconductor device further comprises a plurality of through-layer vias in the second shower block and electrically connecting the at least one semiconductor chip and the printed circuit board to each other.

9. The semiconductor device of claim 8, further comprising:
a plurality of nozzle-via groups each comprising a subset of the plurality of second nozzles arranged from each other in a second direction and the plurality of through-layer vias between the plurality of second nozzles, the plurality of nozzle-via groups arranged from each other in a first direction perpendicular to the second direction; and
a plurality of second outlet groups each comprising a subset of the plurality of second outlets arranged in the first direction, the plurality of second outlet groups arranged from each other in the second direction such as to between the plurality of nozzle-via groups.

10. The semiconductor device of claim 9, wherein the second shower block comprises:
a plurality of second inlet channels configured to supply the cooling liquid to the plurality of second nozzles; and
a plurality of second outlet channels connected to the plurality of second outlets,
wherein the plurality of second inlet channels extend in the first direction and are arranged from each other in the second direction, and
wherein the plurality of second outlet channels extend in the second direction and are arranged from each other in the first direction.

11. The semiconductor device of any preceding claim, wherein the cavity comprises an upper cavity defined by the first shower block and a lower cavity defined by the second shower block, and
wherein the upper cavity and the lower cavity are not connected to each other.

12. The semiconductor device of any preceding claim, wherein the cavity comprises an upper cavity defined by the first shower block and a lower cavity defined by the second shower block, and
wherein the upper cavity and the lower cavity are in communication with each other.

13. The semiconductor device of any preceding claim, wherein the at least one semiconductor chip is a plurality of semiconductor chips stacked on each other.

14. The semiconductor device of any preceding claim, wherein the at least one cooling block is a first cooling block and a second cooling block on the first cooling block,
wherein the at least one semiconductor chip comprises at least one first semiconductor chip within the first cooling block and at least one second semiconductor chip within the second cooling block.

15. The semiconductor device of claim 14, wherein
the first shower block further comprises:
a plurality of first inlet channels configured to supply the cooling liquid to the plurality of first nozzles; and
a plurality of first outlet channels connected to the plurality of first outlets, and
the second shower block further comprises:
a plurality of second inlet channels configured to supply the cooling liquid to the plurality of second nozzles; and
a plurality of second outlet channels connected to the plurality of second outlets,
wherein the first cooling block comprises:
a first inlet manifold to which the plurality of first inlet channels and the plurality of second inlet channels are joined; and
a first outlet manifold to which the plurality of first outlet channels and the plurality of second outlet channels are joined,
wherein the second cooling block comprises:
a second inlet manifold to which the plurality of first inlet channels and the plurality of second inlet channels are joined; and
a second outlet manifold to which the plurality of first outlet channels and the plurality of second outlet channels are joined,
wherein the first inlet manifold and the second inlet manifold are connected to each other and communicate with an outside of the semiconductor device, and
wherein the first outlet manifold and the second outlet manifold are connected to each other and communicate with the outside, and optionally wherein at least of the plurality of first inlet channels of the first cooling block is connected to the plurality of second nozzles of the second cooling block such as to function as at least one of the plurality of second inlet channels of the second cooling block.

## Amended claims

### Amended claims in accordance with Rule 137(2) EPC.

1. A semiconductor device comprising:
at least one semiconductor chip (2) comprising a semiconductor integrated circuit;
at least one cooling block (3) comprising a first shower block (4) and a second shower block (5) stacked on the first shower block such that the first shower block and the second shower block define a cavity in which the at least one semiconductor chip is accommodated; and
a printed circuit board, wherein the at least one cooling block is on the printed circuit board,
wherein the first shower block comprises:
a plurality of first nozzles (401) configured to spray a cooling liquid into the cavity toward a top surface of the at least one semiconductor chip; and
a plurality of first outlets (402) configured as a first discharge passage that receives the cooling liquid from the cavity, and
wherein the second shower block comprises:
a plurality of second nozzles (501) configured to spray the cooling liquid into the cavity toward a bottom surface of the at least one semiconductor chip; and
a plurality of second outlets (502) configured a second discharge passage that receives the cooling liquid from the cavity;
a plurality of first nozzle groups (401 G) each comprising a subset of the plurality of first nozzles arranged from each other in a second direction, the plurality of first nozzle groups arranged from each other in a first direction, perpendicular to the second direction; and
a plurality of first outlet groups (402G) each comprising a subset of the plurality of first outlets arranged in the second direction from each other, the plurality of first outlet groups arranged in the first direction from each other,
wherein the first shower block further comprises:
a plurality of first inlet channels that are configured to supply the cooling liquid to the plurality of first nozzles; and
a plurality of first outlet channels connected to the plurality of first outlets,
wherein the plurality of first inlet channels extend in the first direction and are arranged in the second direction from each other, and
wherein the plurality of first outlet channels extend in the second direction and are arranged in the first direction from each other.

2. The semiconductor device of claim 1, wherein
the second shower block comprises:
a plurality of second inlet channels that are configured to supply the cooling liquid to the plurality of second nozzles; and
a plurality of second outlet channels connected to the plurality of second outlets.

3. The semiconductor device of claim 2, wherein
the first shower block further comprises a plurality of first block layers, and the plurality of first inlet channels and the plurality of first outlet channels are formed in different layers from among the plurality of first block layers,
the second shower block further comprises a plurality of second block layers, and the plurality of second inlet channels and the plurality of second outlet channels are formed in different layers from among the plurality of second block layers, and
the plurality of first inlet channels and the plurality of first outlet channels are non-parallel to each other, and optionally wherein:
the plurality of first inlet channels and the plurality of second inlet channels extend in a same direction as each other; and
the plurality of first outlet channels and the plurality of second outlet channels extend in a same direction as each other.

4. The semiconductor device of claim 2 or 3, further comprising:
an inlet manifold from which the plurality of first inlet channels and the plurality of second inlet channels branch, wherein the inlet manifold is in the at least one cooling block and communicates with an outside of the semiconductor device; and
an outlet manifold to which the plurality of first outlet channels and the plurality of second outlet channels are joined, wherein the outlet manifold is in the at least one cooling block and communicates with the outside, and optionally wherein the inlet manifold passes through the first shower block to communicate with the outside.

5. The semiconductor device of claim 4, wherein the outlet manifold passes through the first shower block to communicate with the outside.

6. The semiconductor device of claim 4, wherein the outlet manifold passes through the second shower block to communicate with the outside.

7. The semiconductor device of any preceding claim, wherein the second shower block is on the printed circuit board, and
wherein the semiconductor device further comprises a plurality of through-layer vias in the second shower block and electrically connecting the at least one semiconductor chip and the printed circuit board to each other.

8. The semiconductor device of claim 7, further comprising:
a plurality of nozzle-via groups each comprising a subset of the plurality of second nozzles arranged from each other in a second direction and the plurality of through-layer vias between the plurality of second nozzles, the plurality of nozzle-via groups arranged from each other in a first direction perpendicular to the second direction; and
a plurality of second outlet groups each comprising a subset of the plurality of second outlets arranged in the first direction, the plurality of second outlet groups arranged from each other in the second direction such as to between the plurality of nozzle-via groups.

9. The semiconductor device of claim 8, wherein the second shower block comprises:
a plurality of second inlet channels configured to supply the cooling liquid to the plurality of second nozzles; and
a plurality of second outlet channels connected to the plurality of second outlets,
wherein the plurality of second inlet channels extend in the first direction and are arranged from each other in the second direction, and
wherein the plurality of second outlet channels extend in the second direction and are arranged from each other in the first direction.

10. The semiconductor device of any preceding claim, wherein the cavity comprises an upper cavity defined by the first shower block and a lower cavity defined by the second shower block, and
wherein the upper cavity and the lower cavity are not connected to each other.

11. The semiconductor device of any preceding claim, wherein the cavity comprises an upper cavity defined by the first shower block and a lower cavity defined by the second shower block, and
wherein the upper cavity and the lower cavity are in communication with each other.

12. The semiconductor device of any preceding claim, wherein the at least one semiconductor chip is a plurality of semiconductor chips stacked on each other.

13. The semiconductor device of any preceding claim, wherein the at least one cooling block is a first cooling block and a second cooling block on the first cooling block,
wherein the at least one semiconductor chip comprises at least one first semiconductor chip within the first cooling block and at least one second semiconductor chip within the second cooling block.

14. The semiconductor device of claim 13, wherein
the first shower block further comprises:
a plurality of first inlet channels configured to supply the cooling liquid to the plurality of first nozzles; and
a plurality of first outlet channels connected to the plurality of first outlets, and
the second shower block further comprises:
a plurality of second inlet channels configured to supply the cooling liquid to the plurality of second nozzles; and
a plurality of second outlet channels connected to the plurality of second outlets,
wherein the first cooling block comprises:
a first inlet manifold to which the plurality of first inlet channels and the plurality of second inlet channels are joined; and
a first outlet manifold to which the plurality of first outlet channels and the plurality of second outlet channels are joined,
wherein the second cooling block comprises:
a second inlet manifold to which the plurality of first inlet channels and the plurality of second inlet channels are joined; and
a second outlet manifold to which the plurality of first outlet channels and the plurality of second outlet channels are joined,
wherein the first inlet manifold and the second inlet manifold are connected to each other and communicate with an outside of the semiconductor device, and
wherein the first outlet manifold and the second outlet manifold are connected to each other and communicate with the outside, and optionally wherein at least of the plurality of first inlet channels of the first cooling block is connected to the plurality of second nozzles of the second cooling block such as to function as at least one of the plurality of second inlet channels of the second cooling block.
